# NEW EUROPEAN PATENT SPECIFICATION

(11) **EP 0 588 906 B2**
(45) Date of publication and mention of the opposition decision: **18.06.2003**
(45) Mention of the grant of the patent: 02.08.2000
(21) Application number: 92912738.9
(22) Date of filing: 19.05.1992
(51) Int. Cl.: H01B 1/00, H01B 1/12, C08G 73/02, H01L 33/00

(54) **PROCESSIBLE FORMS OF ELECTRICALLY CONDUCTIVE POLYANILINE AND CONDUCTIVE PRODUCTS FORMED THEREFROM**
ANWENDBARE FORMEN VON ELEKTRISCH LEITFÄHIGEN POLYANILINEN UND DAVON HERGESTELLTE LEITFÄHIGE PRODUKTE
FORMES DE POLYANILINE ELECTRIQUEMENT CONDUCTRICES POUVANT ETRE TRAITEES ET PRODUITS CONDUCTEURS CONSTITUES DE CETTE MATIERE

(30) Priority: 12.06.1991 US 714165; 27.11.1991 US 800555; 27.11.1991 US 800559
(43) Date of publication of application: 30.03.1994
(73) Proprietor: DuPont Displays, Inc., Santa Barbara, CA 93117 (US)
(72) Inventor: CAO, Yong, Goleta, CA 93117 (US); SMITH, Paul, Santa Barbara, CA 93105 (US); HEEGER, Alan, J., Santa Barbara, CA 93103 (US)
(74) Representative: Goldin, Douglas Michael
(86) International application number: US9204167
(87) International publication number: WO92022911

(56) References cited:
- WO-A-89/01694
- WO-A-90/10297
- WO-A-90/13601
- WO-A-92/18572
- JP-A- 2 240 163
- US-A- 4 851 487
- US-A- 4 935 163
- US-A- 5 008 041
- US-A- 5 079 096
- US-A- 5 093 439
- US-A- 5 133 841
- US-A- 5 567 355
- CRC Handbook of Chemistry and Physics, 62. Auflage, E-53, CRC Press, Inc, 1981-1982
- Der Laborkatalog Merck, Seite 479, " Ethylmethylketon"

## Description

### Background of the Invention

### 1. Field of the Invention

This invention relates to conductive polymers and particularly to the use of functionalized protonic acids to induce processibility of electrically conductive substituted or unsubstituted polyanilines, and to induce solubility of electrically conductive substituted or unsubstituted polyanilines in organic liquids and/or fluid (melt) phases of solid polymers. Other aspects of this invention relate to the resulting solutions of electrically conductive substituted or unsubstituted polyanilines in organic liquids, to solution-processing methods of forming such solutions and to methods of using such solutions to form conducting polymer articles. Yet other aspects relate to solid phase polymers containing these protonic acids and their use in conductive articles.

### 2. Prior Art

There has recently been an increased interest in the electrical conductivity and electrochemistry of polymeric systems. Recently, work has intensified with emphasis on polymers having extended conjugation in the backbone chain.

One conjugated polymer system currently under study is polyaniline. Kobayashi Tetsuhiko et al., J. Electroanal Chem., "Electrochemical Reactions Concerned With electrochromism of Polyaniline Film-Coated Electrodes," 177 (1984) 281-291, describes various experiments in which spectroelectro-chemical measurement of a polyaniline film coated electrode were made. French Patent No. 1,519,729, French Patent of Addition 94,536; U.K. Patent No. 1,216,549; "Direct Current Conductivity of Polyaniline Sulfate," M. Donomedoff, F. Kautier-Cristojini, R. ReSur-vail, M. Jozefowicz, L.T. Yu, and R. Buvet, J. Chim. Phys. Physicohim. Brol., 68, 1055 (1971); "Continuous Current Conductivity of Macromolecular Materials," L.T. Yu, M. Jozefowicz, and R. Buvet, Chim. Macromol., 1,469 (1970); "Polyaniline Based Filmogenic Organic Conductive Polymers," D. LaBarre and M. Jozefowicz, C.R. Read. Sci., Ser. C, 269, 964 (1969); "Recently Discovered Properties of Semiconducting Polymers," M. Jozefowicz, L.T. Yu, J. Perichon, and R. Buyer, J. Polym. Sci., Part C, 22, 1187 (1967); "Electrochemical Properties of Polyaniline Sulfates," F. Cristojini, R. De Surville, and M. Jozefowicz, Cr. Read. Sci., Ser. C, 268,1346 (1979); "Electrochemical Cells Using Protolytic Organic Semiconductors," R. De Surville, M. Jozefowicz, L.T. Yu, J. Perichon, R. Buvet, Electrochem. Ditn. 13, 1451 (1968); "Oligomers and Polymers Produced by Oxidation of Aromatic Amines," R. De Surville, M. Jozefowicz, and R. Buvet, Ann. Chem. (Paris), 2, 5 (1967) "Experimental Study of the Direct Current Conductivity of Macromolecular Compound," L.T. Yu, M. Borredon, M. Jozefowicz, G. Belorgey, and R. Buvet, J. Polym. Sci. Polym. Symp., 16, 2931 (1967); "Conductivity and Chemical Properties of Oligomeric Polyaniline," M. Jozefowicz, L.T. Yu, G. Belorgey, and R. Buvet, J. Polym. Sci., Polym. Symp., 16, 2934 (1967); "Products of the Catalytic Oxidation of Aromatic Amines," R. De Surville, M. Jozefowicz, and R. Buvet, Ann. Chem. (Paris), 2, 149(1967); "Conductivity and Chemical Composition of Macromolecular Semiconductors," Rev. Gen. Electr., 75 1014 (1966); "Relation Between the Chemical and Electrochemical Properties of Macromolecular Semiconductors," M. Jozefowicz and L.T. Yu, Rev. Gen. Electr., 75, 1008 (1966); "Preparation, Chemical Properties, and Electrical Conductivity of Poly-N-Alkyl. Anilines in the Solid State," D. Muller and M. Jozefowicz, Bull. Soc. Chem. Fr., 4087 (1972).

United States Patent Nos. 3,963,498 and 4,025,463 describe oligomeric polyanilines and substituted polyanilines having not more than 8 aniline repeat units which are described as being soluble in certain organic solvents and which are described as being useful in the formation of semiconductors compositions. European Patent No. 0017717 is an apparent improvement in the compositions of United States Patent Nos. 3,963,498 and 4,025,463 and states that the polyaniline can be formed into a latex composite through use of the oligomers of polyaniline and a suitable binder polymer.

High molecular weight polyaniline has emerged as one of the more promising conducting polymers, because of its excellent chemical stability combined with respectable levels of electrical conductivity of the doped or protonated material. Processing of polyaniline high polymers into useful objects and devices, however, has been problematic. Melt processing is not possible, since the polymer decomposes at temperatures below a softening or melting point. In addition, major difficulties have been encountered in attempts to dissolve the high molecular weight polymer.

Recently, it was demonstrated that polyaniline, in either the conducting emeraldine salt form or the insulating emeraldine base form, can processed from solution in certain strong acids to form useful articles (such as oriented fibers, tapes and the like). By solution processing from these strong acids, it is possible to form composites, or polyblends of polyaniline with other polymers (for example polyamides, aromatic polyamides (aramids), etc.) which are soluble in certain strong acids and thereby to make useful articles. "Electrically Conductive Fibers of Polyaniline Spun from Solutions in Concentrated Sulfuric Acid," A. Andreatta, Y. Cao, J.C. Chiang, A.J. Heeger and P. Smith, Synth. Met., 26, 383 (1988); "X-Ray Diffraction of Polyaniline," Y. Moon, Y. Cao, P. Smith and A.J. Heeger, Polymer Communications, 30, 196 (1989); "Influence of the Chemical Polymerization Conditions on the Properties of Polyaniline," Y. Cao, A. Andreatta, A.J. Heeger and P. Smith, Polymer, 30, 2305 (1990); "Magnetic Susceptibility of Crystalline Polyaniline," C. File, Y. Cao and A.J. Heeger, Sol. State Commun., 70, 245 (1989); "Spectroscopy and Transient Photoconductivity of Partially Crystalline Polyaniline," S.D. Phillips, G. Yu, Y. Cao, and A.J. Heeger, Phys. Rev. B 39, 10702 (1989); "Spectroscopic Studies of Polyaniline in Solution and in the Solid State," Y. Cao and A.J. Heeger, Synth. Met. 32, 263, (1989); Magnetic Susceptibility of One-Dimensional Chains in Solution," C. Fite, Y. Cao and A.J. Heeger, Solid State Commun., 73, 607 (1990); "Electrically Conductive Polyblend Fibers of Polyaniline and Poly(p-phenylene terephthalamide)," A. Andreatta, A.J. Heeger and P. Smith, Polymer Communications, 31, 275 (1990); "Polyaniline Processed From Sulfuric Acid and in Solution in Sulfuric Acid: Electrical, Optical and Magnetic Properties," Y. Cao, P. Smith and A.J. Heeger in Conjugated Polymeric Materials: Opportunities in Electronics. Opto-electronics, and Molecular Electronics, ed. J.L. Bredas and R.R. Chance (Kluwer Academic Publishers, The Netherlands, 1990).

United States Patent No. 4,983,322 describes solutions and plasticized compositions of electrically conductive substituted and unsubstituted polyanilines and methods of forming such solutions or compositions and use of same to form conductive articles. The polyaniline materials were made soluble by the addition of an oxidizing agent such as FeCl₃. Since the resulting compounds are charge transfer salts, highly polar solvents were required; specifically solvents were needed with dielectric constants equal to or greater than 25 and with dipole moments equal to or greater than 3.25.

Starting with the insulating emeraldine base form, polyaniline can be rendered conducting through two independent doping routes:
(i) Oxidation either electrochemically (by means of an electrochemical charge transfer reaction) or chemically (by means of chemical reaction with an appropriate oxidizing agent such as FeCl₃);
(ii) Protonation through acid-base chemistry by exposure to protonic acids (for example, in aqueous environment with pH less than 2-3). (1) 'Polyaniline': Protonic Acid Doping of the Emeraldine Form to the Metallic Regime by J.-C. Chiang and Alan G. MacDiarmid, Synthetic Metals 13 193 (1986). (2) A Two-Dimensional-Surface 'State' Diagram for Polyaniline by W. R. Salaneck, I. Lundstrom, W.-S Huang and A.G. MacDiarmid, Synthetic Metals 13, 297 (1986).

These two different routes lead to distinctly different final states. In (i), the oxidation causes a change in the total number of π-electrons on the conjugated chain and thereby renders it conductive. In (ii), there is no change in the number of electrons; the material is rendered electrically conductive by protonation of the imine nitrogen sites.

In the general field of conducting polyaniline, it was believed impossible to dope a high molecular weight polyaniline to the extent that it becomes a semiconductor or conductor and thereafter dissolve or plasticize the conductive form of polyaniline in common nonpolar or weakly polar organic solvents. As used herein, the terms "to plasticize" and a "plasticized composition" refer to the process and product in which a solid polymer includes an admixed liquid or semisolid phase to an extent sufficient to render the solid polymer flexible (softened) and not brittle. The liquid or semisolid additive is known as a "plasticizer." The nature of plasticized materials is described in more detail in Harry R. Allcock and Frederick W. Lampe, Contemporary Polymer Chemistry, Prentice-Hall, Inc. Englewood Cliffs, N.J. (1981), p. 13.

In the absence of solutions or plasticized forms, comprising common nonpolar or weakly polar liquids, or otherwise processible forms, the ability to readily and economically form useful conductive articles out of conductive polyaniline, or composites or polyblends of conductive polyaniline with other polymers (for example polyethylene, polypropylene, polystyrene, elastomers, poly(ethylvinylacetate), etc.) is restricted. Thus, a need exists for techniques and materials to facilitate the fabrication of shaped conductive polyaniline articles, especially articles made from bulk material (conductive polyanilines and/or composites, or polyblends of conductive polyaniline with other polymers) and films, fibers and coatings.

In one aspect, this invention provides and the soluble conductive polyanilines provided lead to transparent conductive polymers. Prior art in this area includes Shacklette et al. (U.S. Patent No. 4,963,206, Oct. 16, 1990) applied a conductive polyaniline film onto Aclar by exposing the Aclar film to a mixture of aniline tosylate and ammonium persulfate in an aqueous solution of tosic acid. Thus the conductive polyaniline film was polymerized *in situ* onto the substrate. Fukunishi et al. (JP application no. 63145326, June 17, 1988) used similar techniques to prepare polymer composites by in situ polymerization of pyrrole and aniline. Takahashi et al. (JP application no. 63268733) prepared thin semitransparent films by electrolytic polymerization. Sakai et al. (JP application no. 63215772, Sept. 8, 1988) manufactured conductive polymer compositions by polymerizing monomers capable of forming anionic polymer electrolytes in the presence of polymers of π-conjugated structure. Transparent thin films were deposited electrolytically.

In another aspect this invention applies its conductive polymers in the formation of novel light-emitting diode (LED) structures. References to LEDs and their fabrication include: Burroughs, J.H., Bradley, D.D.C., Brown, A.R., Marks, R.N., Mackay, K., Friend, R.H., Burns, P.L. and Holmes, A.B., Nature, 347, 539-541 (1990); Braun, D. and Heeger, A.J., Applied Physics Letters, 58, 1982-1984 (1991); Burn, P.L., Holmes, A.B., Kraft, A., Bradley, D.D.C., Brown, A.R., Friend, R.H., and Gymer, R.W., Nature, 356, 47-49 (1992); and Grem, G., Leditzky, G., Ulrich, B., and Leising, G., Advanced Materials, 4, 36-38 (1992).

### SUMMARY OF THE INVENTION

The present invention relates to electrically conducting polymeric compositions. These compositions include a conductive polyaniline in intimate admixture (solution or the like) with a substrate material. The term "substrate" is used to indicate a range of nonconductive and semiconducting (i.e., conductivity of 10⁻⁸ S-cm⁻¹ or less) organic liquids and polymers of dielectric constant below 22. More particularly, these compositions include polyaniline of film and fiber-forming molecular weight, a substrate and functionalized protonic acid dopant in which the counter-ion has been functionalized to be compatible with the substrate. The substrate can be solid polymer. It can be this polymer in melted (molten) form. It can separately or in addition be organic solvent. As used herein, a "functionalized protonic acid" is a protonic acid, generally denoted as H⁺(M⁻-Rₚ), in which the counter-ion anionic species, (M⁻-Rₚ), contains Rₚ which is a functional group or a connection to a polymer backbone which is chosen to be compatible with the substrate which typically includes nonpolar or weakly polar organic liquids, or solid or molten oligomers or polymers. An illustrative example would be the following:
M⁻ = SO₃⁻
Rₚ = dodecyl-benzene.
In cases where the functionalized protonic acid is a liquid or has plastic properties, it may replace some of the substrate.

Thus, in one aspect this invention provides highly conductive, highly processible, cost-efficient forms of polyaniline-based conductive polymers. These materials are characterized by having a substrate (as above described), polyaniline and protonic acid dopant which has a counter-ion selected to be compatible with the substrate. These materials can be solids with a solid polymer substrate, or they can be processible liquids or semisolids with a molten polymer and/or a solvent optionally plus dissolved polymer as the substrate.

The solid products of the invention are characterized by being highly conductive at unexpectedly low concentrations of the polyaniline/dopant conductive species. This conductivity shows that the products present the polyaniline as a continuous (i.e., dissolved) phase rather than as a dispersed particulate phase. Microexamination has verified this in that solid polymer-substrated materials have a continuous web of the polyaniline even at low (less than 10%, even less than 1%, or sometimes even less than 0.1%) polyaniline concentrations.

The products of this invention are also characterized by being capable of being formed in transparent forms depending upon the materials employed.

Another aspect of this invention relates to a method of forming a conductive article from the substrated composition of this invention which compromises the steps of:
a. forming a solution comprising polyaniline, a substrate including an organic liquid solvent optionally a substrate polymer and a functionalized protonic acid compatible with said solvent and said optional polymer; and
b. removing all or a portion of said solvent from said solution after or concurrent with shaping the solution into the desired article.

Yet another aspect of this invention relates to a method of forming a conductive article from the composition of this invention which compromises the steps of:
a. forming a solution comprising polyaniline, a liquid substrate of organic liquid monomers and a functionalized protonic acid compatible with said substrate; and
b. polymerizing the monomers in said solution, after or concurrent with shaping the solution into the desired article.

Yet another aspect of this invention relates to methods of forming a conductive article which is a composite, or polyblend of conductive polyaniline with substrate polymers (for example polyethylene, polypropylene, polystyrene, elastomers, poly(ethylenevinylacetate), polyvinylchloride, etc.) from a solution which compromises the steps of:
a. forming a solution comprising polyaniline, a solvent and a functionalized protonic acid compatible with the solvent and substrate polymers and one or more substrate polymers (for example polyethylene, polypropylene, polystyrene, elastomers, polyamides, poly(ethylenevinylacetate), polyvinylchloride, etc.); and
b. removing all or a portion of said solvent from said solution, thereby giving rise to the conductive article.

Yet another aspect of this invention relates to methods of forming a solid conductive article which is a composite, or polyblend of conductive polyaniline with substrate polymers which compromises the steps of:
a. forming a solution comprising polyaniline, a monomer precursor to said substrate polymer, a substrate made of organic liquid monomers and a functionalized protonic acid solute compatible with said substrate and monomer; and
b. polymerizing the monomer to yield a solid, optionally with solvent removal.

Yet another aspect of this invention relates to methods of forming a conductive article of conductive polyaniline with substrate by:
a. forming a melt comprising polyaniline, a functionalized protonic acid solute and a molten polymer substrate selected from the group consisting of nonpolar or weakly polar thermoplastic polymers; and
b. solidifying said melt.

Any of these processes can additionally contain the step of drawing or otherwise distorting the shape of the article to improve its physical and electrical properties.

Still another aspect of this invention relates to conductive articles and conductive layers, made from polyblends of polyaniline with one or more substrate polymers, in accordance with this invention.

The compositions and methods of this invention provide conductive articles, made from polyaniline and one or more substrate polymers, of all shapes, as for example, articles fabricated by injection molding or bulk extrusion, or articles fabricated by use of the methods of solution processing (for example flexible films, tapes, or fibers), on supports or free-standing, all of which are stable. The articles can be optical quality, or transparent.

In a particular embodiment the polymers of the invention are formed into conductive layers for use in light-emitting diodes which can be flexible and colored, if desired.

In this aspect, a flexible light-emitting diode which is formed using soluble polyaniline (PANi) cast from a solution onto a flexible polymer substrate as the transparent, flexible, hole-injecting electrode and using a semiconducting (conjugated) polymer cast from solution as the electroluminescent layer. The semiconducting (conjugated) polymer is present either in the conjugated form (and therefore requiring no subsequent heat treatment at elevated temperatures) or as a precursor polymer (which is subsequently converted to the semiconducting form by heat treatment at elevated temperatures).

These light-emitting diodes can have flexible conducting polyaniline as the transparent injecting electrode, semiconducting (conjugated) polymers as the active electroluminescent layer and flexible free-standing organic polymer films as substrates. These LEDs can be formed to turn on at bias voltages compatible with digital electronics (i.e., at voltages less than 5 volts).

### Brief Description of the Drawings

Figures 1A and B are graphs which show the concentration in solution of a conducting polyaniline-dodecylbenzsulfonic acid (DBSA) protonic acid complex in xylene as a function of the molar ratio of the total amount of DBSA to aniline repeat unit.
Figure 2A shows a graph of the four-probe electrical conductivity of polyblend films prepared from xylene solutions of polyaniline-DBSA complex and isotactic polypropylene versus the composition of the films.
Figure 2B shows a graph of the four-probe electrical conductivity of polyblend films prepared from m-cresol solutions of polyaniline-CSA complex and nylon 12 or nylon 4.6 versus the composition of the films. The open and filled symbols refer to nylon 12 and nylon 4.6, respectively.
Figure 3 is a graph of the four-probe electrical conductivity of polyblend films prepared from xylene solutions of polyaniline-DBSA complex and ultra-high molecular weight polyethylene versus the composition of the films. The open symbols are of undrawn, (isotropic) films; the filled circles are of the films that were stretched on a hot plate at 105°C to a draw ratio of 40.
Figure 4 is a graph of the four-probe electrical conductivity as a function of the composition of polyblends films that were prepared from chloroform solutions of polyaniline-DBSA complex and polystyrene or poly(3-octylthiophene). The open and filled symbols refer to polystyrene and poly(3-octylthiophene), respectively.
Figure 5 is a graph of the four-probe electrical conductivity of polyblend films prepared from a melt of polyaniline-DBSA complex and polyethylene versus the composition of the films. The open and filled symbols refer to compositions in which the molar ratio of DBSA to aniline repeat unit (PhN) was 0.5 and 1.0, respectively.
Figure 6 is a graph of the four-probe electrical conductivity of polyblend films prepared from a melt of polyaniline-DBSA complex and nylon 12 versus the composition of the films. The molar ratio of DBSA to aniline repeat unit (PhN) was 0.5.
Figure 7 shows a graph of the four-probe electrical conductivity of polyblend films prepared from a melt of polyaniline-DBSA complex and poly(vinylchloride) versus the composition of the films in the absence and presence of the plasticizer Mesamoll. The open triangles and circles refer to compositions in which the molar ratio of DBSA to aniline repeat unit (PhN) was 0.5 and 1.0, respectively. The filled circles refer to compositions in which the molar ratio between PhN, DBSA and Mesamoll was 1:0.5:0.5.
Figure 8 shows a graph of the four-probe electrical conductivity of polyblend films prepared from a melt of polyaniline-dioctylhydrogenphosphate (DOHP) complex and polyvinylchloride versus the composition of the films. The molar ratio of DOHP to aniline repeat unit (PhN) was 0.33.
Figure 9 is a series of visible transmittance spectrographs for three PANi/CSA films;
Figure 10 is a graph of conductivity of PANi/CSA/PMMA films at various PANi concentrations;
Figure 11 is a series of visible transmittance spectrographs for PANi/CSA/PMMA films;
Figure 12 is a series of visible transmittance spectrographs for different thickness PANi/CSA/PMMA films;
Figure 13 is a series of visible transmittance spectrographs for PANi/CSA/PMMA films;
Figure 14 is a series of visible transmittance spectrographs for PANi/CSA/PMMA films;
Figure 15 is a graph of conductivity of PANi/DBSA/PMMA films at various PANi concentrations;
Figure 16 is a graph of conductivity of PANi/CSA/PVAc films at various PANi concentrations;
Figure 17 is a series of visible transmittance spectrographs for PANi/CSA/PVAc films;
Figure 18 is a graph of conductivity of PANi/CSA/PC films at various PANi concentrations;
Figure 19 is a graph of conductivity of PANi/CSNpoly(acrylonitrile) films at various PANi concentrations; and
Figure 20 is a series of visible transmittance spectrographs for various PANi/CSA/polymer films.
Figure 21 is a semi-schematic perspective view of an LED of this invention.
Figure 22 is a graph of absorbance and photoluminescence as a function of wavelength for an LED of this invention.
Figure 23 is a graph of current as a function of bias voltage for an LED of this invention.
Figure 24 is a graph of light intensity observed with these LEDs as a function of bias voltage.

### DETAILED DESCRIPTION OF THE INVENTION

The conductive materials and layers provided and employed in this invention typically include three types of ingredients.
(i) One or more substituted or unsubstituted polyanilines;
(ii) An organic substrate phase. This can be a solid or fluid phase. It can be an organic liquid. It can also be an organic solid or semisolid such as melted or softened polymer, or in a special circumstance can be the protonic acid
(iii) when it is a liquid and not overly polar in overall character--i.e., when it has a large nonpolar region. It can be mixtures of two or more of these materials. It has a dielectric constant below 22.
(iii) One or more functionalized protonic acid solutes in which the counter-ion has been functionalized to be compatible with the substrate.

By proper selection, these materials can provide transparent conductive products.

### The Polyaniline

One ingredient is substituted or unsubstituted polyaniline. When the term "polyaniline" is used in this application, it is used generically to include substituted and unsubstituted materials, unless the context is clear that only the specific nonsubstituted form is intended. The aniline repeat units of the polyaniline are N-unsubstituted. In general, polyanilines for use in the invention are polymers and copolymers of film and fiber-forming molecular weight derived from the polymerization of unsubstituted and substituted anilines of the Formula I: 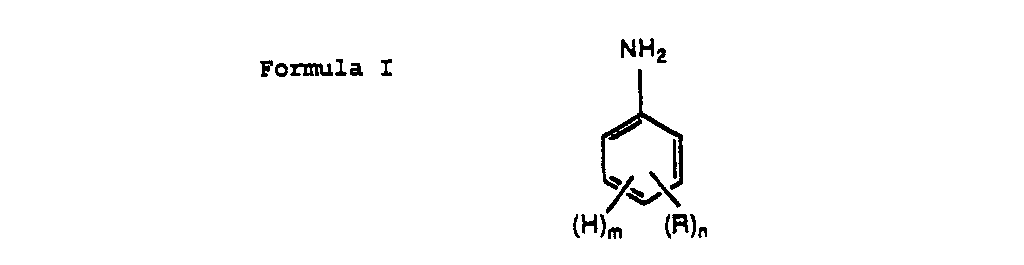 wherein
n is an integer from 0 to 4;
m is an integer from 1 to 5 with the proviso that the sum of n and m is equal to 5; and
R is independently selected so as to be the same or different at each occurrence and is selected from the group consisting of alkyl, alkenyl, alkoxy, cycloalkyl, cycloalkenyl, alkanoyl, alkythio, aryloxy, alkylthioalkyl, alkylaryl, arylalkyl, amino, alkylamino, dialkylamino, aryl, alkylsulfinyl, alkoxyalkyl, alkylsulfonyl, arylthio, arylsulfinyl, alkoxycarbonyl, arylsulfonyl, carboxylic acid, halogen, cyano, or alkyl substituted with one or more sulfonic aid, carboxylic acid, halo, nitro, cyano or expoly moieties; or carboxylic acid, halogen, nitro, cyano, or sulfonic acid moieties; or any two R groups together may form an alkylene or alkenylene chain completing a 3, 4, 5, 6 or 7-membered aromatic or alicyclic ring, which ring may optionally include one or more divalent nitrogen, sulfur or oxygen atoms. Without intending to limit the scope of this invention, the size of the various R groups ranges from about 1 carbon (in the case of alkyl) through 2 or more carbons up through about 20 carbons with the total of n Rs being from about 1 to about 40 carbons.

Illustrative of the polyanilines useful in the practice of this invention are those of the Formula II to V: 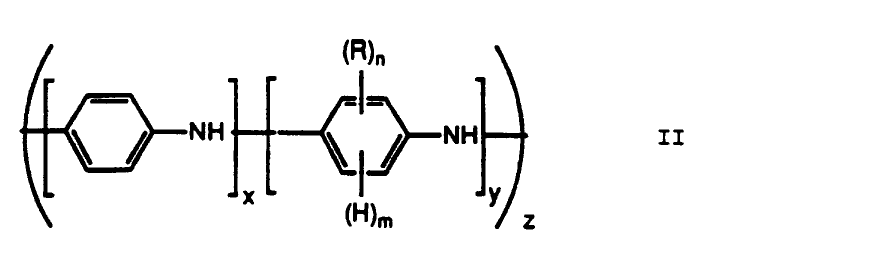 or 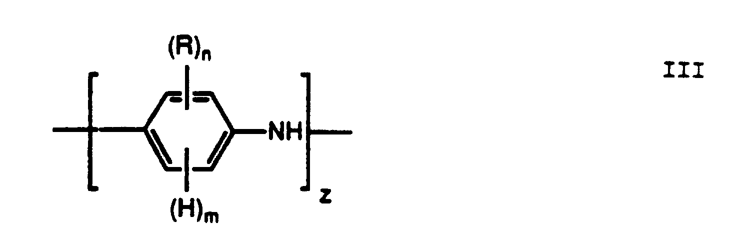 or 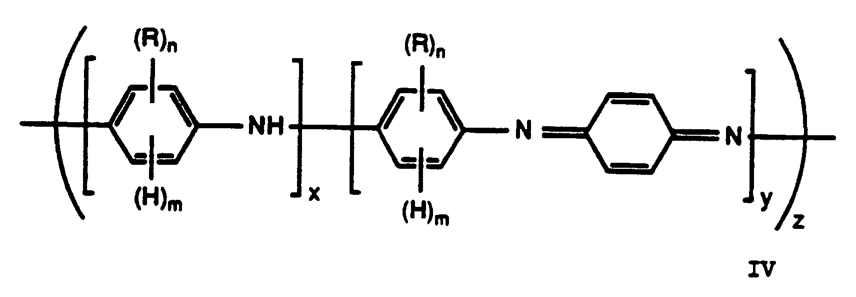 or 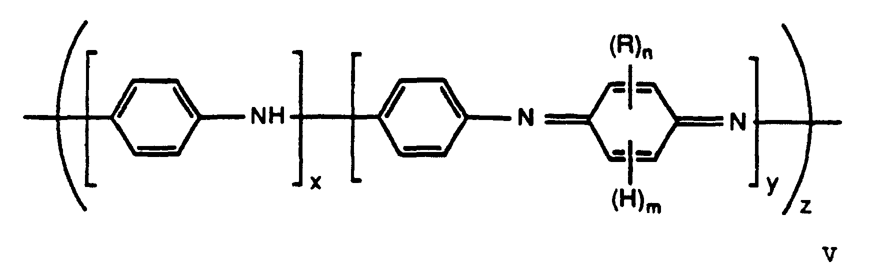 wherein:
n, m and R are as described above except that m is reduced by 1 as a hydrogen is replaced with a covalent bond in the polymerization and the sum of n plus m equals 4;
y is an integer equal to or greater than 0;
x is an integer equal to or greater than 1, with the proviso that the sum of x and y is greater than 1; and
z is an integer equal to or greater than 1.

The following listing of substituted and unsubstituted anilines are illustrative of those which can be used to prepare polymers and copolymers useful in the practice of this invention.

| | |
|---|---|
| Aniline | 2,5-Dimethylaniline |
| o-Toluidine | 2,3-Dimethylaniline |
| m-Toluidine | 2,5-Dibutylaniline |
| o-Ethylaniline | 2,5-Dimethoxyaniline |
| m-Ethylaniline | Tetrahydronaphthylamine |
| o-Ethoxyaniline | o-Cyanoaniline |
| m-Butylaniline | 2-Thiomethylaniline |
| m-Hexylaniline | 2,5-Dichloroaniline |
| m-Octylaniline | 3-(n-Butanesulfonic acid) |
| 4-Bromoaniline | aniline |
| 2-Bromoaniline | |
| 3-Bromoaniline | 2,4-Dimethoxyaniline |
| 3-Acetamidoaniline | 4-Mercaptoaniline |
| 4-Acetamidoaniline | 4-Methylthioaniline |
| 5-Chloro-2-methoxyaniline | 3-Phenoxyaniline |
| 5-Chloro-2-ethoxyaniline | 4-Phenoxyaniline |

Illustrative of useful R groups are alkyl, such as methyl, ethyl, octyl, nonyl, tert-butyl, neopentyl, isopropyl, sec-butyl, dodecyl and the like, alkenyl such as 1-propenyl, 1-butenyl, 1-pentenyl, 1-hexenyl, 1-heptenyl, 1-octenyl and the like; alkoxy such as propoxy, butoxy, methoxy, isopropoxy, pentoxy, nonoxy, ethoxy, octoxy, and the like, cycloalkenyl such as cyclohexenyl, cyclopentenyl and the like; alkanoyl such as butanoyl, pentanoyl, octanoyl, ethanoyl, propanoyl and the like; alkylsulfinyl, alkysulfonyl, alkylthio, arylsulfonyl, arylsulfinyl, and the like, such as butylthio, neopentylthio, methylsulfinyl, benzylsulfinyl, phenylsulfinyl, propylthio, octylthio, nonylsulfonyl, octylsulfonyl, methylthio, isopropylthio, phenylsulfonyl, methylsulfonyl, nonylthio, phenylthio, ethylthio, benzylthio, phenethylthio, naphthylthio and the like; alkoxycarbonyl such as methoxycarbonyl, ethoxycarbonyl, butoxycarbonyl and the like, cycloalkyl such as cyclohexyl, cyclopentyl, cyclooctyl, cycloheptyl and the like; alkoxyalkyl such as methoxymethyl, ethoxymethyl, butoxymethyl, propoxyethyl, pentoxybutyl and the like; aryloxyalkyl and aryloxyaryl such as phenoxyphenyl, phenoxymethylene and the like; and various substituted alkyl and aryl groups such as 1-hydroxybutyl, 1-aminobutyl, 1-hydroxylpropyl, 1-hydyroxypentyl, 1-hydroxyoctyl, 1-hydroxyethyl, 2-nitroethyl, trifluoromethyl, 3,4-epoxybutyl, cyanomethyl, 3-chloropropyl, 4-nitrophenyl, 3-cyanophenyl, and the like; sulfonic acid terminated alkyl and aryl groups and carboxylic acid terminated alkyl and aryl groups such as ethylsulfonic acid, propylsulfonic acid, butylsulfonic acid, phenylsulfonic acid, and the corresponding carboxylic acids.

Also illustrative of useful R groups are divalent moieties formed from any two R groups such as moieties of the formula:

-(CH₂)-_{n*}

wherein n* is an integer from about 3 to about 7, as for example -(CH₂)-₄, -(CH₂)-₃ and -(CH₂)-₅, or such moieties which optionally include heteroatoms of oxygen and sulfur such as -CH₂SCH₂- and -CH₂-O-CH₂-. Exemplary of other useful R groups are divalent alkenylene chains including 1 to about 3 conjugated double bond unsaturation such as divalent 1,3-butadiene and like moieties.

Preferred for use in the practice of this invention are polyanilines of the above Formulas II to V in which:
n is an integer from 0 to about 2;
m is an integer from 2 to 4, with the proviso that the sum of n and m is equal to 4;
R is alkyl or alkoxy having from 1 to about 12 carbon atoms, cyano, halogen, or alkyl substituted with carboxylic acid or sulfonic acid substituents;
x is an integer equal to or greater than 1;
y is an integer equal to or greater than 0, with the proviso that the sum of x and y is greater than about 4, and
z is an integer equal to or greater than about 5.

Particularly preferred for use in the practice of this invention are polyanilines of the above Formulas II to V in which:
n is an integer from 0 to 2;
m is an integer from 2 to 4, with the proviso that the sum of n and m is equal to 4;
R is alkyl or alkoxy having from 1 to about 4 carbon atoms or alkyl substituted with carboxylic acid or sulfonic acid substituents;
x is an integer equal to or greater than 1;
y is an integer equal to or greater than 0, with the proviso that the sum of x and y is greater than about 6; and
z is an integer equal to or greater than about 10.

Amongst the particularly preferred embodiments, most preferred for use in the practice of this invention are polyanilines of the above Formulas II to V in which:
n is an integer, 0 or 1;
m is an integer, 3 or 4, with the proviso that the sum of n and m is equal to 4;
R is alkyl or alkoxyl from 1 to about 4 carbon atoms;
x is an integer equal to or greater than 2;
y is an integer equal to or greater than 1, with the proviso that the sum of x and y is greater than about 8; and
z is an integer equal to or greater than about 15.

In the most preferred embodiments of this invention, the polyaniline is derived from unsubstituted aniline, i.e., where n is 0 and m is 5 (monomer) or 4 (polymer).

The polyanilines useful in the practice of this invention are those which are of "film and fiber-forming molecular weight." As used herein, "film and fiber-forming molecular weight" generally means weight average molecular weights which exceed 10,000 daltons. Solutions of such soluble polymers generally can be cast to form thin, freestanding films or extruded into films and fibers which are coherent and retain their shape, and preferably are not brittle when bent.

In general, an advantage of this invention is that substituted and unsubstituted polyanilines in the protonated conducting form may be dissolved in organic liquids and such polyanilines have more than 8 monomer repeat units. These are more highly condensed than the polyanilines described in United States Patent Nos. 3,963,498 and 4,025,463. Because of the higher molecular weight, the present substituted and unsubstituted polyanilines can be coated onto surfaces and spun into fibers without the need for binders, i.e., polymer compositions which bind and improve the stability of the polyanilines which is not generally true of the low molecular weight oligomeric polyanilines described in United States Patent Nos. 3,963,498 and 4,025,463. The molecular weight of the substituted or unsubstituted polyaniline at which the polymer will be film or fiber-forming may vary widely, depending on a number of factors including the number of repeat units, and the number of substituents and the substituent pattern. In general. substituted and unsubstituted polyanilines will be of film and fiber-forming molecular weight where the number of monomer repeat units is at least about 50. In the preferred embodiments of the invention, the number of repeat units is at least about 75, and in the particularly preferred embodiments, the number of repeat units is at least about 200. Amongst the particularly preferred embodiments, most preferred are those embodiments in which the number of repeat units is at least about 250.

The polyaniline can be conveniently used in the practice of this invention in any of its physical forms. Illustrative of useful forms are those described in Green, A.G., and Woodhead, A. E., "Aniline-black and Allied Compounds, Part 1," J. Chem. Soc., Vol. 101, pp. 1117 (1912) and Kobayashi, et al., "Electrochemical Reactions ... of Polyaniline Film-Coated Electrodes," J. Electroanal. Chem., Vol. 177, pp. 281-91 (1984), which are hereby incorporated by reference. For unsubstituted polyaniline, useful forms include leucoemeraldine, protoemeraldine, emeraldine, nigraniline and tolu-protoemeraldine forms.

Useful polyanilines can be prepared through use of chemical synthetic procedures. For example, one form of polyaniline having at least about 160 repeat units can be prepared by treating aniline with ammonium persulfate (NH₄)₂S₂O₈ in excess 1M HCI. This powdered form of polyaniline is blue green in color. After methanol washing and air drying this material exhibits a conductivity of about 10 S-cm⁻¹. This conductive form of polyaniline can be treated with ammonium hydroxide in ethanol to form a nonconductive form of polyaniline which is purple in color and which has a conductivity of less than 10⁻⁸ S-cm⁻¹. Other chemical procedures for preparation of various chemical forms of polyaniline are described in detail in Green et al. described above.

Useful forms of polyaniline can also be prepared electrochemically. For example, useful forms of polyaniline can be prepared by the electrochemical oxidation of aniline in aqueous fluoroboric acid electrolyte on a platinum foil anode.

### The Functionalized Protonic Acid

A second ingredient of the conductive composition of this invention is a "functionalized protonic acid" in which the counter-ion has been functionalized to be compatible with nonconductive liquid or polymer substrates. As used herein, a "protonic acid" is an acid that protonates the polyaniline to form a complex with said polyaniline, which complex has a conductivity equal to or greater than about 10⁻³S/cm. Amongst these embodiments, preferred are those protonic acids which form a polyaniline complex having a conductivity of greater than 0.1 S/cm. Protonic acids are well known as dopants in the conductive polymer art as shown by the reference to J.C. Chiang and Alan G. MacDiarmid; and the reference to W.R. Salaneck et al., noted above, but are not necessarily compatible with nonconductive substrates such as nonpolar or weakly polar organic liquids. As used herein a "functionalized" protonic acid is an acid that protonates the polyaniline to form a complex with said polyaniline, which complex has a conductivity equal to or greater than about 10⁻¹ S/cm⁻¹ and which has been functionalized to be miscible with or soluble in (as opposed to merely dispersible in) the substrate which makes up the third component of these products. In view of these properties, the acid can be considered a solute and the substrate a solvent.

This functionalization allows the polyaniline complex to be homogenized into the substrate through solubilization, or the like. This dissolving and/or intimate mixing leads to an essentially continuous network of the conductive species in the substrate. The substrate can be present as a discontinuous phase or preferably as a co-continuous phase. This imparts a high level of conductivity to the overall composition--a conductivity many times higher than would be achieved if the conductive species were present as suspended particles or the like.

As will be set out below, the substrate phases which are employed include organic liquids and/or melted polymers. In determining "compatibility" between a functionalized protonic acid and a substrate, the usual chemical solubility-miscibility rules are followed. For example with more polar substrates such as ketones or esters (as organic solvents) or poly(esters), poly(arylates) or poly(amides) as polymers--functionalization in the protonic acid counter-ion should promote or at minimum not substantially diminish the polar nature of the counter-ion group.

Conversely, with the preferred nonpolar or weakly polar substrates such as, for example, alkanes or aromatic hydrocarbons or halohydrocarbons as liquids or poly(olefins), vinyl polymers, such as polystyrene, polymethacrylates, or elastomers, such as ethylene propylene diene monomer copolymers am polymer substrates-functionalization should impart a nonpolar or weakly polar region to the counter-ion (for example adding a hydrocarbon tail to the counter-ion) so as to enhance or impart solubility of the counter-ion into the nonpolar substrate.

In one sense, in the case of nonpolar substrates, the acid is acting as a surfactant and thereby renders the polar counter-ion compatible with nonpolar or weakly polar organic substrates. Functionalized protonic acids for use in the invention are those of Formulas VI and VII:

A-R₁ VI

wherein A is sulfonic acid, phosphonic acid, hydrogen sulfate, or hydrogen phosphate; and R₁ is 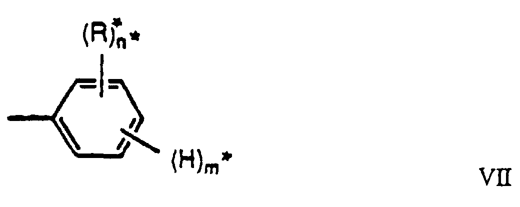 wherein: m* is 4 and n* is 1 and the counter-ion includes R* and is alkyl, alkenyl or alkoxy, having from 2 to 14 carbon atoms or alkyl substituted with one or more carboxylic acid, halogen, nitro, cyano or epoxy moieties;
or A is HOSO₂- and R₁ is selected from the group consisting of (L, D)-10-camphor-, O-anisidine-5-, hydroxybenzene-, 2-hydroxy-4-methoxy-benzophenone-, dinonylnaphthalene-, 4-morpholineethane-, and 2-{[tris (hydroxymethyl) methyl]amino}-1-ethane-;
or A is hydrogen phosphate and R₂ is bis(2-ethyl hexyl)
or A-R is diphenyl hydrogen phosphate.

It will be appreciated that the depiction of the acids as A-R₁ is equivalent to their earlier depiction as H⁺(M⁻-Rₚ) and that the 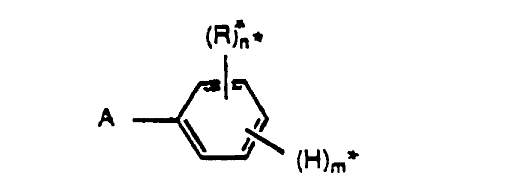 acids fall within the general structure of A-R₁.

Among the particularly preferred embodiments, most preferred for use in the practice of this invention are functionalized protonic acid solutes of the above Formulas VI and VII in which:
A is sulfonic acid;
n* is 1;
m* is 4;
R* is alkyl or alkoxy, having from 4 to 14, especially 12 carbon atoms, or alkyl substituted with one or more halogen, moieties.

In the preferred embodiments of this invention, the functionalized protonic acid solute is dodecylbenzene sulfonic acid.

The amount of functionalized protonic acid employed can vary depending on the degree of conductivity required. In general, sufficient functionalized protonic acid is added to the polyaniline-containing admixture to form a conducting material. The amount of functionalized protonic acid employed is at least sufficient to give a conductive polymer (either in solution or in solid form) having a conductivity of greater than about 10⁻³ g-cm⁻¹. As a general rule, the amount needed will be much lower, i.e., 10 % by weight (basis overall composition) or less than would be expected to impart the desired conductivity. This is because the functionalized counter-ion of the protonic acid is dissolved or intimately mixed in the substrate rather than merely dispersed or suspended in it. The upper level of conductivity is not critical and may depend on the type of aniline polymer employed. In general, the highest level of conductivity obtained is provided without unduly adversely affecting the environmental stability of the polymer.

### The Substrate

A third component of the materials of this invention is a substrate. Substrates are insulating or semiconducting materials. The substrate can be an organic solvent, or it can be bulk oligomeric or polymeric or prepolymeric materials which can be put into a fluid (liquid or semisolid) form during processing so as to achieve the required intimate mixture (solution or the like) with the polyaniline and dopant. In the case of nonpolar counter-ions, it is preferred to use nonpolar or weakly polar solvents or polymers as substrates. As used herein the terms "nonpolar or weakly polar organic solvent, or oligomeric or polymer liquid" and the like refer to a material which is or can be rendered fluid by melting and which has a dielectric constant at room temperature equal to or less than about 22. Preferred of these substrates are those common organic solvents, or meltable malleable oligomers or polymers with dielectric constants equal to or less than about 15. Especially preferred nonpolar substrates are those solvents, or oligomers or polymers with dielectric constants equal to or less than about 10.

Illustrative of useful common solvents are the following materials: substituted or unsubstituted aromatic hydrocarbons such as benzene, toluene, p-xylene, m-xylene, naphthalene, ethylbenzene, styrene, aniline and the like; higher alkanes such as pentane, hexane, heptane, octane, nonane, decane and the like; cyclic alkanes such as decahydronaphthalene; halogenated alkanes such as chloroform, bromoform, dichloromethane and the like; halogenated aromatic hydrocarbons such as chlorobenzene, o-dichlorobenzene, m-dichlorobenzene, p-dichlorobenzene and the like; alcohols such as m-cresol, benzylalcohol, 2-butanol, 1-butanol, hexanol, pentanol, decanol, 2-methyl-1-propanol and the like; higher ketones such as hexanone, butanone, pentanone and the like; heterocyclics such as morpholine; perfluorinated hydrocarbons such as perfluorodecaline, perfluorobenzene and the like. Mixtures of such nonpolar organic solvents can also be used as for example mixtures of xylene and chlorobenzene.

Examples of semiconducting (i.e., materials with conductivities of up to 10⁻⁸ S-cm⁻¹) include undoped or lightly doped conjugated homo- or copolymers such as polythiophenes, polypyrroles, polyacetylenes, polyparaphenylene sulfide, poly(paraphenylene vinylenes), and the like.

Other useful substrates include liquefiable (meltable) bulk oligomers or polymers. Illustrative of useful oligomeric liquids are liquefiable higher alkanes such as hexatriacontane, dotriadecane, octadodecane; branched higher alkanes and waxes, and perfluorinated higher alkanes and waxes. Illustrative of useful polymeric substrates are liquefiable polyethylenes, isotactic polypropylene, polystyrene, poly(vinylalcohol), poly(ethylvinylacetate), polybutadienes, polyisoprenes, ethylenevinylene-copolymers, ethylene-propylene copolymers, poly(ethyleneterephthalate), poly(butyleneterephthalate) and nylons such as nylon 12, nylon 8, nylon 6, nylon 6.6 and the like. Mixtures of organic solvents plus polymers may be used in which case the solvent can serve as a plasticizer for the polymer.

Organic substrates selected for use in any particular situation will depend primarily on the various R substituents of the polyaniline, and/or of the functionalized protonic acid, and/or one or more other polymers that are selected to form a blend with the substituted or unsubstituted polyaniline. In general, less polar substituents and/or less polar other polymers used the preparation of polyblends, will require lower dielectric constants. Conversely, more polar substituents and/or more polar other polymers used the preparation of composites or polyblends, will require higher dielectric constants.

Preferred common organic solvents are toluene, xylenes, styrene, aniline, decahydronaphthalene, chloroform, dichloromethane, chlorobenzenes, morpholine, and particularly preferred solvents are toluene, xylenes, decahydronaphthalene, and chloroform. Amongst these embodiments are those in which the solvents are aromatic hydrocarbons such as xylene, and halogenated hydrocarbons such as chloroform.

### Overall Proportions

The proportions of materials are not critical and can vary widely. However, the following guidelines are believed important for achieving materials particularly useful in the present invention. The amount of functionalized protonic acid may play a part in determining whether a plasticized composition or a solution is formed. In general, the higher the degree of protonation (with associated functionalized counter-ions), the greater the solvency of the protonated conducting polymer in the solvent. Conversely, the lower the degree of protonation (and the lower the concentration of functionalized counter-ions), the less the solvency of the conducting polymer in the solvent, but the polymer is still plasticizable. For example, as shown in Examples 5 and 6, in the case of unsubstituted polyaniline where the level of protonation is about 1.0 or more equivalents of functionalized protonic add per aniline repeat unit, soluble conductive polyaniline is provided. However, where the level of protonation is less than about one equivalent of protonic acid per aniline repeat unit, plasticizable conductive polymers are formed. As noted above, sufficient protonation occurs to form either the soluble conductive polymer or plasticized conductive polymer. In a preferred embodiment of this invention, the level of protonic acid addition is such that solutions of conductive polymers are obtained.

In general, the amount of solvent substrate as a proportion of the amount of solution is not believed to be critical, since any amount as a liquid or semisolid will form at least a viscous gel with the protonated conductive polymers. These viscous embodiments of the invention are particularly useful for silkscreening conductive circuitry and for applying thick film coating on substrates. For other applications, it may be preferred, however, to use sufficient liquid solvent to lower the viscosity of the gel or solution to a point where it flows at least sufficiently to conform to a container shape or mold in a reasonably short period of time, e.g., in 30 minutes or less; or the be extruded into films and fibers. Preferably, the liquid is present in sufficient amounts to lower the viscosity of the solution to less than about 10,000 centipoise, and more preferably from about 1 to about 1000 centipoise.

As just described, the conductive polymer compositions of this invention include polyaniline, protonic acid, and solvent or plasticizer substrate (which can be protonic acid in some cases, as already noted). The relative proportions of these materials can range as follows:
0.01% to 100% by weight of polyaniline plus protonic acid
99.99% of substrate, preferably
0.01% to 99% by weight of polyaniline plus protonic acid,
99.99% to 1% of substrate, and more preferably
0.05 to 50% of polyaniline plus protonic acid and
99.95 to 50% of substrate.

These proportions can be expressed for very preferred compositions to include
Polyaniline
1 part by weight.
Protonic acid
From at least 1 protonic acid proton for each 10 repeat units of aniline and preferably at least one for each 8 repeat units up to 20 protonic acid protons for each aniline repeat unit--typically from 0.01 parts to 20 parts by weight.
Substrate (including excess acid)
0.1 parts to 500 parts, especially 0.2 to 200 parts.

In addition to the polyaniline homopolymer or copolymer, functionalized protonic acid and substrate the compositions of this invention can include other optional ingredients. The nature of such optional ingredients can vary widely, and include those materials which are known to those of skill in the art for inclusion in polymer articles. In the case of dissolvable components, materials may be present which alter the physical or mechanical properties of either the solution or the articles eventually derived from the solution. Examples of such materials include plasticizers, oligomers or other conventional polymers such as polycarbonate, polyacrylonitrile, polyvinyl chloride, polyvinylidine chloride, polyvinyl alcohol, polyethylene oxide, polystyrene, nylon, cellulose acetate butyrate, polypropylene, polyethylene, polypropylene cellulose acetate, polyphenylene oxides and the like. In the case of non-soluble fourth components, materials may be present which either fill or form a base for the conductive polymer cast from the composition. These fourth components may include other conductive polymers, other polymers such as poly(3-alkylthiophenes) which may become conductive upon doping, graphite, metal conductors, reinforcing fibers and inert fillers (such as clays and glass). These fourth components can be present in as much as 98% of the total mixture, and being optional can be omitted altogether. Usually, for commercially attractive products these added fourth components make up 2% to 95% by weight of the total final product.

### Processing

The method of forming the compositions of this invention can vary widely. It is important, however, that at some stage the substrate be processed with the polyaniline and dopant in a fluid (liquid, semisolid, or molten form) to assure proper intimate admixture.

For example, one method of forming the present products containing the protonated aniline polymer and the functionalized counter-ions is to react, simultaneously, the aniline polymer, the functionalized protonic acid and solvent as a liquid. Thus, for example, by introducing polyaniline as a solid powder, xylene as a liquid and dodecylbenzene sulfonic acid (DBSA) as a liquid into a mixing vessel, a solution of the protonated conductive polymer is formed, from which conductive polymer can be cast. The conditions of such mixing are not critical, provided that sufficient DBSA is used to dope the desired quantity of polymer and sufficient solvent is employed to reduce the viscosity of the solution to manageable levels.

An alternate technique of preparing the product of this invention containing the protonated conductive polymer is to mix first the polymer and the solvent, thereafter add the functionalized protonic acid to the solution or two phase system. Thus, for example, if polyaniline powder is admixed with xylene solvent, the powder will remain suspended in the solvent for extended periods under normal conditions. The addition of a functionalized protonic acid to this suspension, such as DBSA, causes the powder to be protonated and, thereafter, causes the protonated conductive polymer to swell and go into solution.

In another method, the solid polymer powder is first mixed with the functionalized protonic acid, such as DBSA, which causes the polymer to be protonated. Subsequently, the protonated polymer is admixed with, for example, xylene and a solution is formed.

Another method for the preparation of solutions containing the polyaniline homopolymer or copolymer and the functionalized protonic add is where the polymer is synthesized directly in the presence of the functionalized protonic acid and in the non-polar or weakly polar solvent or plasticizing liquid, as described in Example 16. This method is of special interest because the functionalized protonic acid acts as a surfactant in this emulsion polymerization, and yields high molecular weights of the polymers, and high conductivities of the resulting materials derived from the emulsions.

In another method, materials of the present invention can be prepared in three steps. First a soluble conducting polyaniline complex consisting of polyaniline in the emeraldine salt form complexed with (M⁻ - Rₚ) as counter-ion where H⁺(M⁻ - Rₚ) is a functionalized protonic acid. An illustrative example would be
M⁻ = SO₃⁻
Rₚ = camphor.

Then the soluble conducting polyaniline complex is co-dissolved with a desired amount of PMMA or any other suitable amorphous bulk polymer in a suitable organic solvent. The concentrations of the two components (the conducting polyaniline complex and, for example, the PMMA) are chosen so as to give a desired ratio in the final conducting film (which may be transparent after casting onto the base and evaporation of the solvent.

The conducting film is then cast onto a base for use as an electrode, an anti-static coating, etc. The detailed method of casting (spin-casting drop-casting, use of a doctor blade, etc.) is chosen to be consistent with secondary criteria (for example, ease of manufacture, cost, shape of substrate, etc).

An alternative route has two steps. First, a polyblend of conducting substituted or unsubstituted polyaniline complex and PMMA (or another amorphous, melt-processible bulk polymer) is prepared using the methods just described followed by evaporation of the solvent to yield a solid polyblend of the desired composition. A film is formed by melting and coating the conducting polyblend onto a desired surface. This alternative has the specific advantage that conducting electrodes can be formed directly onto a base with a complex surface.

After forming the products or forms, including the conductive polymers of this invention, one can often enhance their physical or electrical properties by drawing or otherwise distorting them. This process and guidelines to its successful use are set out in the Examples.

Various methods are contemplated for using the solution or plasticized composition of the present invention. The solvent can be removed from the solution through use of any conventional solvent removal method but is removed preferably by evaporation. Alternatively, the solvent and unreacted functionalized protonic acid can be removed by extraction with an extractant in which the solvent and unreacted functionalized protonic acid are substantially more soluble than the doped polymer. If liquefied or molten oligomers or polymers are used as the substrate, solid conducting articles can be formed simply by cooling the liquid composition, as is commonly performed in injection molding, melt extrusion, etc. Alternatively, when polymerizable monomers are employed as the solvent, solid conducting articles can be formed by polymerizing the monomer. In the two latter methods removal of the solvent is not required.

As will be appreciated by those skilled in polymer processing, the ability to form shaped polymer articles by removing a solvent from a solution enables one to prepare articles of a wide variety of shapes and sizes. Thus, for example, by removing volatiles from the present solution or plasticized composition spread on a surface, films of any desired thickness can be prepared. By extruding the solution through a die, fibers or films can be made. Similarly, by removing volatiles from the solution or plasticized composition in a mold of various shapes, shaped articles conforming in shape to the mold can be prepared. It will be appreciated that some shrinkage might occur between the solution in its last flowable state to the final article, but such shrinkage is conventionally accounted for in molding polymers from solution. It is also contemplated that, once a solution or melt is formed, a partial or substantial removal of solvent will occur prior to placing the solution or melt on a surface or in a mold, with the final venting of a solvent occurring on the surface or in the mold. It is contemplated that, if fourth or additional soluble components are introduced into the solution, they will, unless also volatile, be present in the shaped article formed. If the fourth component is a non-volatile liquid, then the removal of volatile components may leave a new liquid or plasticized form of protonated conducting polymer or undoped-neutral polymer. If the additional components are volatile, then foamed or expanded cellular forms of the polymer may be formed.

In the event that fourth or additional nonsoluble components are present (or suspended) in the solution or melt, the protonated conductive polymer will form around, or be filled with, the insoluble material. If, for example, the additional components are glass fibers, the relative amounts of fibers and protonated conductive polymer remaining will cause either the polymer to be fiber-filled, the fibers to be polymer coated or impregnated, or some intermediate composite of fibers and protonated conductive polymer to be formed. In the case of systems wherein the amount of non-soluble component greatly exceeds the protonated conductive polymer remaining, individual particles or shapes of non-soluble components coated or impregnated with protonated conductive polymer will be formed. Examples of articles formed from nonsoluble components and the present polymer solutions or melts include conductive polymer coated housings for sensitive electronic equipment (microprocessors), infrared and microwave absorbing shields, flexible electrical conducting connectors, conductive bearings, brushes and semi-conducting photoconductor junctions, antistatic materials for packaging electronic components, carpet fibers, waxes for floors in computer rooms and an antistatic spray finisher for plastics, and thin, optically transparent antistatic finishes for CRT screens, aircraft, auto windows and the like.

It is also contemplated to use the present solutions or melts as such as either liquid conductors or liquid semiconductors, much in the manner that liquid mercury is used in various devices. Examples of such devices include gravity switches, fluid level detecting devices or other electrical or electronic switches. Such use is based upon the conductivity of the solution, which the case of polyaniline protonated with DBSA in xylene can represent a relatively high electrical conductivity.

The following specific examples are present to illustrate the invention and are not to be construed as limitations thereon.

### Example 1

Polyaniline was prepared according to the method described by Y. Cao, A. Andereatta, A.J. Heeger and P. Smith, Polymer, 30 (1989) 2305; A solution of 40 ml of freshly distilled aniline (Aldrich), 50 ml of 35% HCI (Fisher) and 400 ml distilled water was prepared in an 1L Erlenmeyer flask. The flask was placed in a cooling bath maintained at 0°C. Polymerization was effected by addition of an oxidant solution consisting of 46 g of (NH₄)₂S₂O₈ (Aldrich) and 100 ml of distilled water. After all oxidant was added (2 hr), the flask was capped and left stirring for an additional 3 hours. The precipitated polymer powder was recovered, filtered and washed with distilled water until the pH of washing liquid was 6-7. Subsequently, the polymer was washed with methanol until the liquid was clear, and then with ethyl ether to eliminate residual water and methanol. Finally, the polymer was dried in a vacuum at room temperature for 48 hours. Emeraldine base form of polyaniline was prepared by compensation of the polyaniline salt. Ten g of polyaniline salt was stirred with 1000 ml of 3% NH₄OH solution during 2 hours at room temperature. The resulting emeraldine base was filtrated and washed by distilled water until the pH of washing liquid was 7-8. Subsequently, the polymer was washed by methanol until washing liquid was colorless and then, with methyl ether. The emeraldine base was dried in dynamic vacuum at room temperature for 48 hours. The resulting polymer was insoluble in all common non-polar or weakly polar solvents, and of high molecular weight; the inherent viscosity of the nonconducting polyaniline measured at 25°C in 97% sulfuric acid, 0.1% w/w, was 1.2 dL/g.

### Example 2

The nonconductive form of polyaniline as prepared in Example 1,5.43 g (0.06 M of aniline), was mixed thoroughly with 9.79 g (0.03 M) of p-dodecylbenzene sulfonic add (DBSA) (Tokyo Kasei) using an agate mortar and pestle in a dry bag filled with nitrogen. The molar ratio of DBSA to aniline repeat unit was 0.5; sufficient to completely protonate the emeraldine base form into the conducting salt form.

### Example 3

Example 2 was repeated with different protonic acids. The electrical conductivity of pressed pellets of the resulting materials are shown in Table 1, together with the conductivity of the material of Example 2.

**Table 1.**

| Conductivity (σ) of emeraldine salt protonated with different protonic acids | |
|---|---|
| Acid | σ (S/cm) |
| Sulfonic acids: | |
| H | 22 |
| CH₃ | 71 |
| C₂H₅ | 79 |
| C₆H₁₃ | 10 |
| C₈H₁₇ | 19 |
| CF₃ | 10 |
| C₈F₁₇ | 4.8 |
| 3-hydroxypropane- | 35.5 |
| (L,D)camphor- | 1.8 |
| (1S)-(+)-camphor- | 2.7 |
| (1R)-(-)-camphor- | 2.0 |
| dioctylsulfosuccinate | 5.8 |
| benzene- | 41 |
| p-toluene- | 22 |
| 4-ethyl-benzene- | 17 |
| m-xylene-4- | 1.4 |
| 4-dodecyl-benzene- | 26.4 |
| m-nitrobenzene- | 5.4 |
| O-anisidine-5- | 7.7x10⁻³ |
| p-chlorobenzene- | 7.3 |
| p-hydroxybenzene- | 6.3 |
| 2,4,5-trichlorobenzene- | 1.3x10⁻¹ |
| aniline-2- | 2.0x10⁻² |
| 4-nitrotoluene-2- | 5.7x10⁻² |
| m-phenylenediamine- | 2.0x10⁻³ |
| 2-hydroxy-4-methoxy-benzophenone-5- | 1.3x10⁻³ |
| 2-naphthalene- | 0.05 |
| 1-diazo-2-naphthalene-4- | |
| dinonylnaphthalene- | 0.2 |
| 8-hydroxy-5,7-dinitro-2-naphthalene- | 8.0x10⁻³ |
| 4-hydroxy-3-nitroso-1-naphtalene- | 2.4x10⁻³ |
| 3-pyridine- | 1.0x10⁻¹ |
| 8-ethoxyquinoline-5- | 1.3x10⁻⁵ |
| | |
| polystyrene-p- | 0.1 |
| poly(maleic anhydride-styrene-p-) | 10⁻⁶ |
| | |

| Other: | |
|---|---|
| dodecyl sulfate | 4 |
| tetra-n-butylammonium hydrogene sulfate | 2.7x10⁻⁵ |
| C₄F₉COOH | 4.5x10⁻⁴ |
| C₈F₁₇COOH | 2.7 |
| C₆F₅OH | 6.8x10⁻³ |
| C₆H₅(BOH)₂ | 1.4x10⁻⁷ |
| bis(2-ethyl hexyl hydrogen phosphate) | 7 |
| diphenyl hydrogen phosphate | 1.5 |
| * pressed at 165° C for 30 sec. | |

This example illustrates that polyaniline may be protonated with a great variety of protonic acids.

### Example 4

The material of Example 2, 0.1 g, was mixed with 0.1 g of DBSA. The mixture was placed into 20 g of xylene; and treated in an ultrasonic bath for 48 hours and subsequently centrifuged. Most of the polyaniline-DBSA complex dissolved to give a deep green solution. Some insoluble solids were removed by decanting.

### Example 5

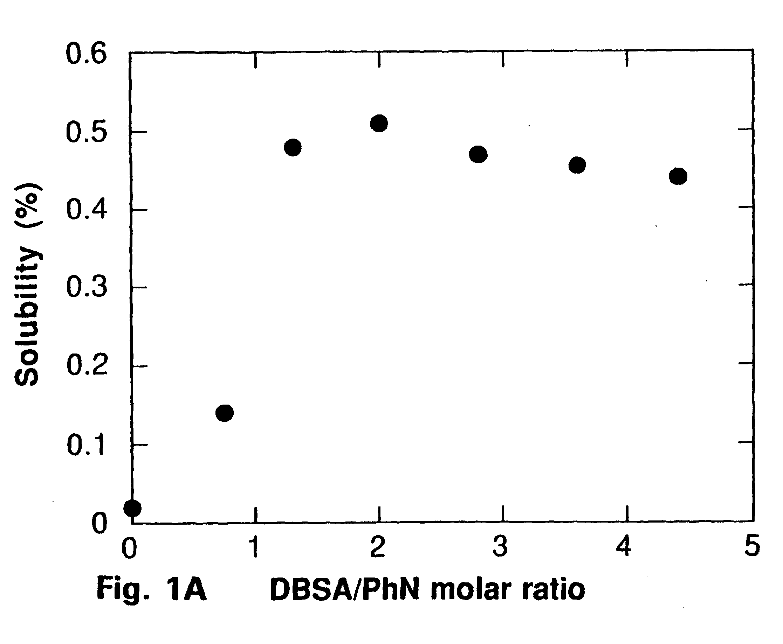

The solution of Example 4 was evaporated to yield a solid, which was washed with acetone to remove excess DBSA. The polyaniline-DBSA complex thus obtained was weighed to calculate the content of the conductive polyaniline complex in said solution. Then, Example 2 was repeated but with the additional amount of DBSA varied over the following values: 0 (which is the reference material of Example 2), 0.05, 0.2, 0.3, 0.4, 0.5 g. The concentration of the conducting polyaniline-DBSA complex in said solutions was determined; and plotted against the molar ratio of the total amount of DBSA to PhN in the solution is shown in Figure 1A. These results illustrate that, in order to obtain a soluble conductive polyaniline-DBSA, more than 0.5 equivalents of functionalized protonic acid per aniline repeat unit is necessary. Less than this amount results in a doped, conductive, plasticizable form of the polymer.

### Example 6

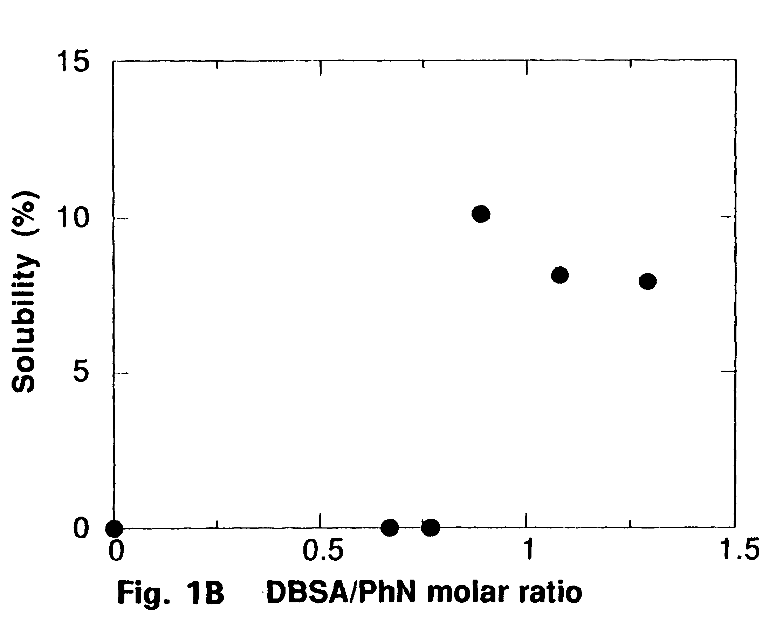

Example 5 was repeated, but the initial amount of PANi-DBSA (DBSA/PhN=0.5) salt was 1 g in 10 g of xylene. The solubility of the complex in xylene versus the DBSA/PhN molar ratio is shown in Fig. 1B.

### Example 7

The material from Example 2 was mixed, in 1 g quantity, with 1 g of additional DBSA to give a molar DBSA/aniline ratio of 1.3. The solubility of the resulting mixture was tested in several different solvents; 0.1 gram of the mixture was placed in 10 g of the various solvents and stirred at room temperature for 1 hr. The results are shown in Table 2.

**Table 2**

| Solubility of Polyaniline-DBSA (DBSA/PhN =1.3) in Selected Solvents | | |
|---|---|---|
| Solvent | Soluble | Dielectric Constant (Room Temperature) |
| Toluene | yes | 2.4 |
| 1,2,4-Trichlorobenzene | yes | 5 |
| Chloroform | yes | 4.8 |
| Decalin | yes | 2.2 |
| Xylenes | yes | 2.2.-2.6 |
| *above ∼80°C. | | |

Similar results were obtained by repeating the above experiments in Examples 2 and 5 with hexanesulfonic acid and octanesulfonic acid in place of DBSA.

### Example 8

Example 2 was repeated. PANi-DBSA of molar ratio DBSA/PhN=0.5 were mixed with the different plasticizing agents listed in Table 3. The solubility of the PANi-DBSA complex (DBSA/PhN=0.5) in xylene is also listed in Table 3. This example illustrated that extra DBSA which was used in Example 5 for dissolution of PANi-DBSA complexes in nonpolar organic solvents can be replaced by wide range of nonacidic additives.

**Table 3.**

| Solubility of DBSA/PhN=0.5 in xylene in the presence of plasticizing additives. | | | |
|---|---|---|---|
| **Additives(A)** | **Trade Mark** | **A/PhN molar ratio** | **Solubility (%)** |
| **Phenols:** | | | |
| 4-Hexyloxyphenol | | 0.5 | 0.3 |
| C₆H₁₃OC₆H₄OH | | | |
| 3-pentadecylphenol | | 0.5 | 6.8 |
| CH3(CH2)14C6H4OH | | 0.75 | 10.2 |
| Nonylphenol | | 0.5 | 0.2 |
| C₉H₁₉C₆H₄OH | | | |
| | | 2.0 | 7.1 |
| 4-Dodecylresorcinol | | 0.5 | 1.4 |
| | | 1.0 | 8.7 |
| 4-(tert-Octyl)phenol | | 1.0 | 4.4 |
| (CH₃)₃C-C₆H₁₂C₆H₄OH | | | |
| | | 2.0 | 7.8 |
| 2.6-Di-tert-butyl-4-methylphenol | BHP | 1.0 | 0.7 |
| [(CH₃)₃C]₂C₆H₂(CH₃)OH | | | |
| 3,4- Dimethylphenol | | 1.0 | 0.5 |
| (CH₃)₂C₆H₃OH | | | |
| 2,6-Dimethylphenol | | 1.0 | 1.9 |
| (CH₃)₂C₆H₃OH | | | |

| **Alkyl Sulfonates:** | | | |
|---|---|---|---|
| Methyl p-toluenesulfonate | | 0.5 | 2.0 |
| CH₃C₆H₄SO₃CH₃ | | | |
| Ethyl p-toluenesulfonate | | 0.5 | 2.0 |
| CH₃C₆H₄SO₃C₂H₅ | | | |
| n-Hexyl p-toluenesulfonate | | 0.5 | 0.4 |
| CH₃C₆H₄SO₃C₆H₁₃ | | | |
| Ethyl DBSA | | 0.5 | 0.6 |

| **Sulfonamide:** | | | |
|---|---|---|---|
| Isopropylamine alkylaryl sulfonate C₁₂H₂₅(C₆H₄)SO₃H-(CH₃)₂CHNH₂ | IPAM | 0.5 | 0.8 |

| **Alcohols:** | | | |
|---|---|---|---|
| 1-Dodecanol CH₃(CH₂)₁₀CH₂OH | | 0.5 | 0.2 |
| 1-Tridecanol CH₃(CH₂)₁₁CH₂OH | | 0.5 | 0.3 |
| 1-Docosanol CH₃(CH₂)₂₀CH₂OH | | 0.5 | 0.7 |
| Ethoxylate CH₃(CH₂)ₓCH₂(OCH₂CH₂)ₙOH x=10-14, n=1.3 | Alfonic 1216-22 | 0.5 | 0.9 |
| Ethoxylate CH₃(CH₂)ₓCH₂(OCH₂CH₂)ₙOH x=6-8, n=1.0 | Alfonic 810-40 | 0.5 | 0.5 |
| Ethoxylate CH₃(CH₂)ₓCH₂(OCH₂CH₂)ₙOH x=10-12, n=3 | Alfonic 1412-40 | 0.5 | 0.9 |
| Ethoxylate CH₃(CH₂)ₓCH₂(OCH₂CH₂)ₙOH x=6-8, n=2 | Alfonic 810-60 | 0.5 | 0.4 |
| Poly(oxy-1,2-ethanediyl), alpha-(nonylphenoxy)-Ω-hydroxy (C₂H₄O)₄C₁₅H₂₄O | Legpon CO-430 | 0.5 | 0.3 |
| Sulfated alkyl alcohol ethoxylate ammonium salt | Standapol EA-3 | 0.5 | 0.5 |

### Example 9

Examples 2 and 5 were repeated for (±)-10-camphorsulfonic acid (CSA) instead of DBSA. 2,4 and 8 g PANi-CSA complexes (CSA-PhN0.5 and 0.7) were treated in 100 g m-cresol as in Example 2. The PANi-CSA complex dissolved at room temperature to give a viscous deep green solution. Similar results were obtained with the optically active (1S)-(+)-10-camphorsulfonic acid and (1R)-(-)-10-camphorsulfonic acid. This example illustrates that, in contrast to the PANi-DBSA system, extra functionalized protonic acid (i.e., more than 0.5 equivalents of acid per aniline PhN unit) is not necessary in the case of PANi-CSAk dissolved in m-cresol. The room temperature solubility of PANi-CSA in various organic solvents are listed in Table 4.

**Table 4**

| Solubility of PANI-CSA in some organic solvents | |
|---|---|
| Solvent | Solubility at room temperature |
| m-cresol | ⊕ |
| p-cresol | ⊕ |
| 2-ethylphenol | ⊕ |
| 2-tert-butylphenol | ⊕ |
| diisopropylphenol | ○ |
| α',α",α'"-Trifluoro-m-cresol | ⊕ |
| 3-methoxyphenol | ○ |
| 2-methoxy-4-methylphenol | ○ |
| xylene(+10% nonylphenol) | ○ |
| xylene(+10% pentadecylphenol) | ○ |
| benzyl alcohol | ○ |
| 3-methylbenzyl alcohol | ○ |
| phenoxyethanol | ○ |
| chloroform | ○ |
| dichloroethane | ○ |
| trichlorobenzene | ○ |

| | |
|---|---|
| ⊕ Very soluble; the solubility is more than 10%(w/w). | |
| ○ Soluble; the solubility is less 10%(w/w). | |

### Example 10

The solubility at room temperature of PANi and selected, functionalized protonic acids was tested in some nonpolar and weakly polar organic solvents. The results are listed in Table 5.

**Table 5**

| Solubility at room temperature of PANI protonated with various protonic acids with functionalized counter-ions. | | | | |
|---|---|---|---|---|
| Acid | Solubility | | | |
| | Decaline | Xylene | CH₃Cl | m-cresol |
| Functionalized sulfonic acids: | | | | |
| C₆H₁₃₋ | ○ | ○ | ○ | ○ |
| C₈H₁₇₋ | | ○ | ○ | ○ |
| C₈F₁₇₋ | * | | | |
| 4-dodecyl-benzene- | ⊕ | ⊕ | ⊕ | ○ |
| (L,D)camphor<-> | | | ○ | ⊕ |
| ethylbenzene- | | ○ | ○ | ○ |
| 0-anisidine-5- | | | | ○ |
| p-chlorobenzene- | | | | ○ |
| hydroxybenzene- | | | | ○ |
| trichlorobenzene- | | | | ○ |
| 2-hydroxy-4-methoxy-benzophenone- | | | | ○ |
| 4-nitrotoluene-2- | | | | ○ |
| dinonylnaphthalene- | ○ | ○ | ○ | ○ |
| 4-morpholine ethane- | | | | ○ |
| 2-{[tris(hydroxymethyl)methyl)amino}-1-ethane- | | | | ⊕ |

| Other: | | | | |
|---|---|---|---|---|
| C₈F₁₇COOH | * | | | |
| bis(2-ethyl hexyl hydrogen phosphate) | ⊕ | ⊕ | ⊕ | |
| diphenyl hydrogen phosphate | ○ | ○ | ○ | |

| | | | | |
|---|---|---|---|---|
| ⊕ Very soluble, the solubility is more than 10%(w/w). | | | | |
| ○ Soluble, the solubility is less 10%(w/w). | | | | |
| * Soluble in perfloroalkane, for example, in perfluorodecaline. | | | | |

### Example 11

A solution was prepared as in Example 4 and was cast onto a glass plate. The xylene was evaporated, and the resulting film was washed with acetone to remove excess DBSA. The remaining film was dried at room temperature and had a four-point probe conductivity of 20 S-cm⁻¹.

Similar results were obtained by repeating the above experiment with chloroform, trichlorobenzene, toluene or decaline in place of xylene.

### Example 12

A quantity of 5 g of a solution as prepared in Example 3 was mixed with 0.17 g of ultra-high molecular weight polyethylene (UHMW PE Hostalen GR 412, weight average molecular weight of 2,000,000), 0.01 g of antioxidant and 17.4 ml of xylene and heated in an oil bath at 126.6°C for 1 hour. The resulting hot solution was cast onto an aluminum plate. Xylene was removed by evaporation in air at room temperature. The polyaniline-DBSA complex content was found to 11.8% w/w in the film. Similar experiments were repeated, but the polyaniline-DBSA complex content was varied to be 7.1% and 13.4% w/w, respectively. Part of the films were stretched on a hot plate at 105°C to a draw ratio λ=40 (λ=final length divided by initial length). The stretched films had outstanding mechanical properties: Young's modulus in excess of 40 GPa and tensile strength in excess of 2 GPa. The electrical conductivities of unstretched and stretched films, were measured using the standard four-probe method. The results are summarized in Table 6. The use of drawing in this example is an example of the general use of physical distortion of a conductive polymer structure to drastically improve the physical and electrical properties of the polymer. Any distortion, stretching, drawing or the like in amounts of about a 50% distortion through a 200-fold distortion can be used with advantage.

**Table 6**

| Electrical Conductivity of UHMW PE Composite Films Containing PANi-DBSA | | |
|---|---|---|
| PANi-DBSA content (%) | Conductivity (S-cm⁻¹) | |
| | unstretched | stretched |
| 7.1 | 8.4x10⁻⁴ | 2.5x10⁻² |
| 11.8 | 2.9x10⁻¹ | 3.9 |
| 13.4 | 2.9x10⁻² | 11.5 |

This example demonstrates the feasibility of using this soluble form of conductive polyaniline in the preparation of high-performance polyolefins.

### Example 13

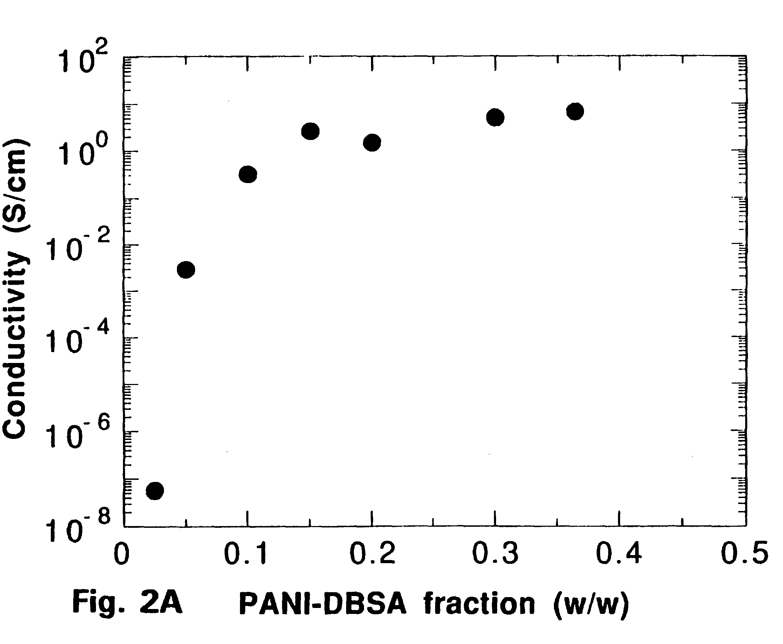

Example 12 was repeated, but isotactic polypropylene (M_{w}∼100,000 daltons) was used instead of ultrahigh molecular weight polyethylene. The electrical conductivities of the blends was measured by the four-point method and are shown in Fig. 2A.

### Example 14

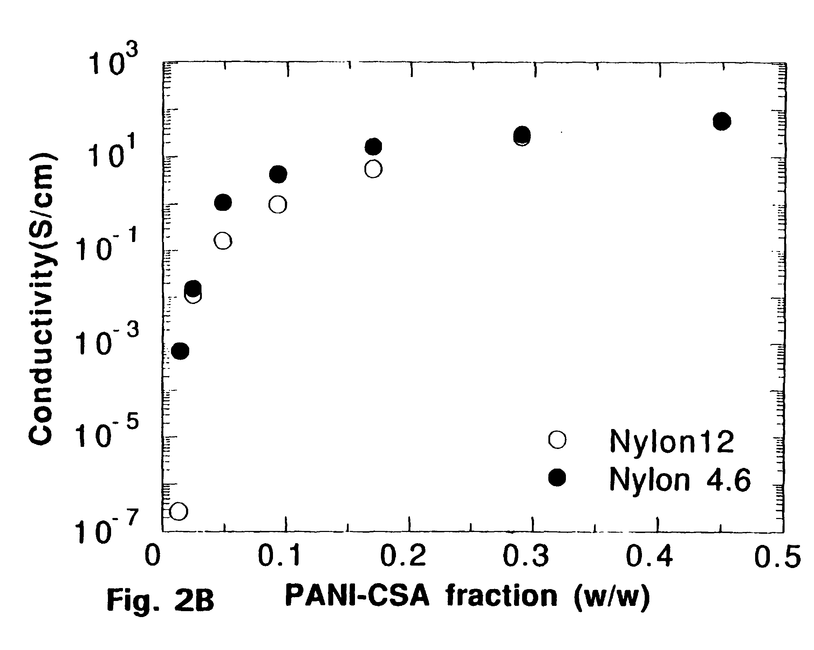

Example 12 was repeated, but with PANi-CSA (CSA/PhN molar ratio = 0.5) in m-cresol, and nylon 4,6 and nylon 12 dissolved in m-cresol were used instead of PANi-DBSA, xylene and ultrahigh molecular weight polyethylene, respectively. Dissolution was carried out at room temperature. The electrical conductivity of the blends was measured by the four-point method and is shown in Fig. 2B.

### Example 15

Experiment 14 was repeated. Similar results were obtained with polystyrene, polycarbonates, amorphous nylons, polyacrylonitrile, poly(methylmethacrylate), polyvinylacetate, polyvinylbutyral, polyvinylpyrrolidone, polysulfone and ABS.

Table 7 summarizes electrical conductivity data of solution-processed blends with a great variety of insulating polymers.

**Table 7**

| Conductivity of solution-processed blends of PANI-functionilized sulfonic acids with various commercial polymers | | | | |
|---|---|---|---|---|
| Host polymer | Acid | Solvent | PANI-salt content in blends of σ=10⁻¹ S/cm | Conductivity σ (S/cm) at weight fraction ω σ(ω) |
| **Homopolymer:** | | | | |
| Polyethylene (PE) | DBSA | xylene, decaline | 0.10 | 5 (0.30) (stretched) |
| | | | | 0.1 (0.30) |
| | | | | (unstretched) |
| Polypropylene (i-PP) | DBSA | xylene | 0.10 | 10 (0.40) |
| Polystyrene (PS) | DBSA | CHCl₃ | 0.20 | 1 (0.40) |
| | CSA | m-cresol | 0.01 | 6 (0.08) |
| Polybutadiene | DBSA | xylene | | 3x10⁻⁶ (0.06) |
| Polysiloxane (Dow Corning | DBSA | xylene | | 1x10-6 (0.02) |
| RTV 738) | | | | |
| Nylon 4.6 | CSA | m-cresol | 0.07 | 50 (0.50) |
| Nylon 12 | CSA | m-cresol | 0.07 | 50 (0.50) |
| Zytel 330 (Du Pont, amor- | CSA | m-cresol | 0.03 | 4.8 (0.08) |
| phous Nylon) | | | | |
| Trogamid (Huls, amorph. | CSA | m-cresol | 0.04 | 4.6 (0.08) |
| Nylon) | | | | |
| Polycarbonate(PC) | CSA | m-cresol | 0.10 | 100 (0.60) |
| Luran PC | CSA | m-cresol | 0.02 | 32 (0.60) |
| Tetramethyl -bis-phenol PC | CSA | m-cresol | 0.01 | 4.8 (0.08) |
| Polyacrylonitril (PAN) | CSA | DMSO | | 10⁻³ (0.40) |
| Poly(methyl metacrylate) | CSA | m-cresol | 0.01 | 70 (0.15) |
| (PMMA) | DBSA | CHCl₃ | 0.10 | 10⁻¹ (0.10) |
| | DBSA | toluene | 0.10 | 10⁻¹ (0.20) |
| Polyvinylacetate | CSA | m-cresol | 0.03 | 50 (0.45) |
| Polyvinylbutyral | CSA | m-cresol | 0.03 | 30 (0.30) |
| Polyvinylpyrrolidone | CSA | m-cresol | 0.03 | 1.9 (0.08) |
| Polysulfone p-1700 | CSA | m-cresol | 0.02 | 5.7 (0.08) |
| **Copolymer:** | | | | |
| ABS | CSA | m-cresol | 0.02 | 26 (0.40) |
| Styrolux (polystyrene-buta- | CSA | m-cresol | 0.03 | 6.4 (0.088) |
| diene) | | | | |

### Example 16

A solution of 4.65 g (0.05 M) of freshly distilled aniline (Aldrich) and 24.48 g (0.075 M) of DBSA and 250 ml xylene was prepared in a 250 ml Erlenmeyer flask. The flask was placed in a bath that was maintained at 25°C. Polymerization was effected by the addition of an oxidant solution containing 4.68 g (0.02 M) of (NH₄)₂S₂O₈ (Aldrich) in 20 ml distilled water. After all oxidant was added (over a period of 30 min), the flask was capped and stirring was continued for 24 hours. The molar ratio of oxidant to aniline was 0.4; the monomer concentration was 0.2 M/L; and the ratio of DBSA to aniline was 1.5. A dark green mixture was formed.

The polymer emulsion was poured into 750 ml acetone and the polyaniline-DBSA complex precipitated. This powder was recovered, filtered and washed three times with 150 ml acetone and three times with 150 ml distilled water, and again three times with 150 ml acetone. Finally, the powder was dried in a vacuum desiccator for 48 hours at room temperature. The polyaniline-DBSA yield was 2.1 g. The DBSA/PhN ratio in the powder was ∼0.3.

This example illustrates that conductive polyaniline-functionalized protonic acid complexes can be prepared directly from the aniline monomer.

This example further illustrates that one can use a protonic acid to solubilize the aniline in an organic solvent and that the solubilized aniline can be subjected to emulsion polymerization, a polymerization technique not available heretofore. In this process, the solvent can be varied as can the protonic acid and the relative proportions of reactants.

### Example 17

Example 16 was repeated, but the polymerization temperature was 0°C and polymerization time was 96 hours. In general terms, the temperature could be varied over the range of -10°C through 50°C with similar results. Times would vary inversely with temperature.

### Examples 18-21

Example 16 was repeated, but the molar ratio of DBSA to aniline was, respectively, 4.0, 3.0, 2.0 and 1.0. The experiment could also be repeated substituting other acids for DBSA.

### Examples 22-25

Example 16 was repeated, but the solvent for the polymerization was, respectively, chloroform (22), toluene (23), decaline (24), 1,2,4-trichlorobenzene (25). Other low dielectric constant nonaqueous liquids could be employed, if desired.

### Example 26

Example 22 was repeated, but the polymerization temperature was 0°C.

The yields of the above polymerizations were calculated from the ratio of the amount of emeraldine base, recovered after compensation (following the procedure of Example 1), to the amount of initial aniline monomer. The electrical conductivity of the polyaniline-DBSA complexes of Examples 16-25 were determined by the usual four-probe method at room temperature on pressed pellets. The inherent viscosity (in dL/g) of the polyaniline-DBSA complex and of the emeraldine base obtained after compensation were determined at 25°C in 97 % H₂SO₄ (0.1% w/w polymer), using an Ubbelohde viscosimeter. The results are presented in Tables 8-10.

**Table 8**

| Effect of Polymerization Temperature | | | | | |
|---|---|---|---|---|---|
| Example | Temperature (°C) | Yield (%) | Conductivity (S-cm⁻¹) | Viscosity (dL/g) | |
| | | | | complex | base |
| 8 | 25 | 32.4 | 3.7 | 0.99 | 1.27 |
| 9 | 0 | 32.6 | 1.0 | 1.21 | 1.70 |
| 14 | 25 | 33.6 | 0.8 | 1.26 | 1.67 |
| 18 | 0 | 36.9 | 0.5 | 1.92 | 2.61 |

The results in this Table illustrates that it is beneficial to carry out the emulsion polymerization at lower temperatures; it also reveals that the direct preparation of polyaniline-functionalized acid complexes in organic solvents may lead to significantly higher molecular weights of the polymer (cf. Example 1).

**Table 9**

| Effect of DBSA/Aniline Ratio | | | | | |
|---|---|---|---|---|---|
| Example | DBSA/aniline Ratio | Yield (%) | Conductivity (S-cm⁻¹) | Viscosity (dL/g) | |
| | | | | complex | base |
| 10 | 4.0 | 27.2 | 0.4 | 0.38 | 0.61 |
| 11 | 3.0 | 37.0 | 0.2 | 0.21 | 0.93 |
| 12 | 2.0 | 34.0 | 0.2 | 0.24 | 0.45 |
| 8 | 1.5 | 32.4 | 3.7 | 0.99 | 1.27 |
| 13 | 1.2 | 32.6 | 0.7 | 0.48 | 0.68 |

The results in this Table illustrate that polyaniline-functionalized acid complexes can be prepared directly over a wide range of DBSA/PhN ratios.

**Table 10**

| Effect of Solvent | | | | | |
|---|---|---|---|---|---|
| Example | Solvent | Yield (%) | Conductivity (S-cm⁻¹) | Viscosity (dL/g) | |
| | | | | complex | base |
| 8 | Xylene | 32.4 | 3.7 | 0.99 | 1.27 |
| 14 | CHCl₃ | 33.6 | 0.8 | 1.26 | 1.67 |
| 15 | Toluene | 36.7 | 1.2 | 1.09 | 1.35 |
| 16 | Decaline | 36.8 | 0.1 | 1.07 | 1.18 |
| 17 | Triclorobenzene | 33.3 | 2.0 | 0.81 | 1.0 7 |

The results in this Table illustrate that the polyaniline-functionalized acid complexes can be prepared directly in various non-polar or weakly polar organic solvents.

### Example 27

The mixture of Example 16 was centrifuged at 4000 rpm for 1 hour immediately after termination of polymerization, prior to precipitation of polyaniline with acetone. The soluble part was decanted and washed three times with 400 mL of a 1:1 acetone/water mixture in separation funnel to eliminate excess DBSA and ammonium sulfate. A bright green solution of the polyaniline-DBSA complex in xylene was obtained, which was stable at room temperature during storage. No precipitate appeared during several months The content of the polyaniline-DBSA complex in the solution was determined by evaporation of the xylene, first in air followed by evacuation in vacuum at room temperature for 24 hours. A typical value of the content was 2% w/w for the polymerization conditions of Example 16.

### Example 28

A mixture was prepared of 0.1 g of the material of Example 16, 0.1 g of DBSA and 20 g xylene was treated in ultrasonic bath overnight. The resulting solution was decanted after centrifugation at 4000 rpm. The concentration of the polyaniline-DBSA complex in the solution was determined as in Example 5. Typically the value of this content was 0.5% w/w. This example illustrates that the powder of Example 16 can be redissolved in xylene.

Similar results were obtained by repeating the above experiment with chloroform, trichlorobenzene, toluene or decaline (at 90 °C) in place of xylene.

### Example 29

A solution was prepared of 0.1 g of the material of Example 27, 0.1 g of DBSA and 10 g xylene, according to the method of Example 28. Free standing films of the polyaniline-DBSA complex were obtained by casting from solution and drying at room temperature and subsequent washing with acetone. Typically, the electrical conductivity of the resulting free standing flexible films was ca. 240 S-cm⁻¹. Because the protonation level of the films obtained by this procedure was only 0.3, further protonation of the film with 1 M aq. HCI solution increases the conductivity to 400 S-cm⁻¹.

This example illustrates that films were produced having values of the electrical conductivity that significantly exceed those commonly reported for polyaniline.

### Example 30

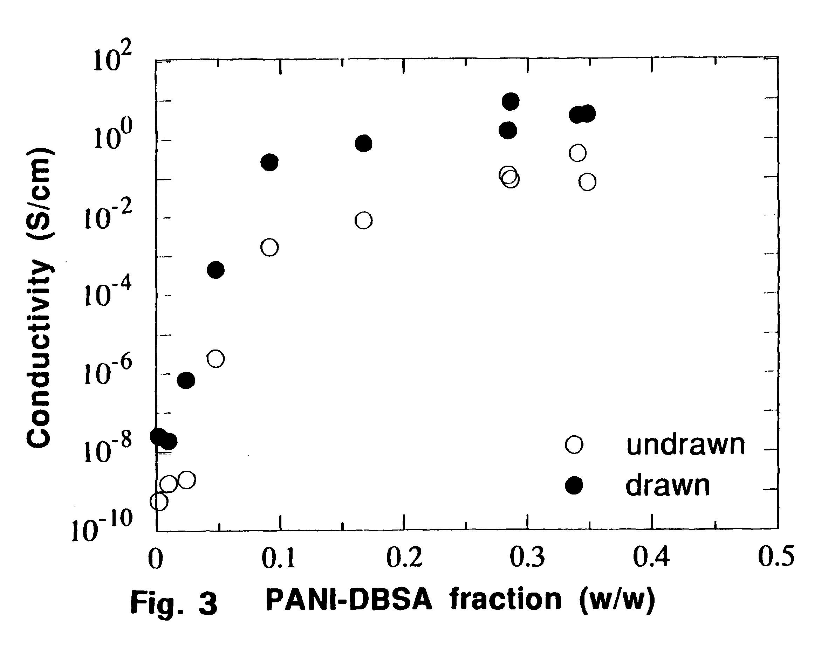

Films were prepared of ultra-high molecular weight polyethylene and the polyaniline-DBSA complex, according to the method of Example 12, but the solution of the conductive polyaniline was directly made according to the method of Example 16. The weight ratios of the polyaniline-DBSA complex to the total polymer content were varied from 0.002, 0.01, 0.024, 0.048, 0.09, 0.17, 0.29, 0.34 to 0.35. After drying the electrical conductivity of polyaniline/UHMW PE blend films were determined using the standard four-probe method. The results are given in Figure 3.

The films were stretched on a hot plate at 105°C to a draw ratio of 1:40. The stretched films exhibited a homogeneous distribution of the polyaniline-DBSA complex in the UHMW PE matrix; and high optical anisotropy was observed under the polarizing light. The electrical conductivity of stretched films were determined using the standard four-probe method. In comparison with the conductivity of unstretched films, the conductivity after drawing increased by 1-3 orders of magnitude depending on the composition of the films (see Fig. 3). The stretched films had outstanding mechanical properties.

This example demonstrates the feasibility of using this soluble form of conductive polyaniline in the preparation of high performance polymer blends of excellent electrical and mechanical properties.

### Example 31

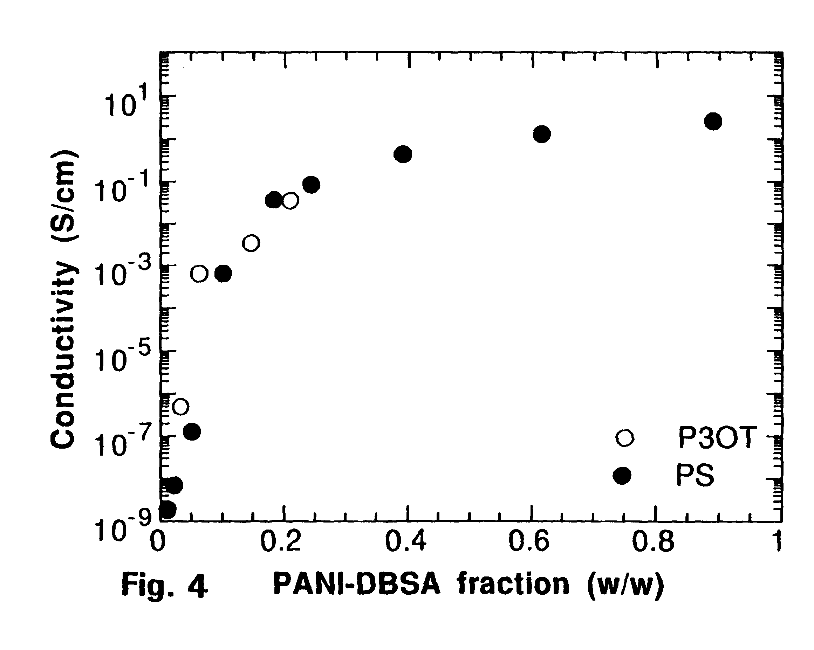

A solution was prepared at room temperature of 2.5 g of polystyrene (Polyscience, M_{w} 125,000-250,000) in 7.5 g chloroform, respectively. A solution of the conductive polyaniline was directly made according to the method of Example 16; and was added to the polystyrene/chloroform solution in amounts such that the weight ratios of polyaniline-DBSA to polystyrene in the chloroform solutions were 0.011, 0.022, 0.05, 0.1, 0.18, 0.24, 0.39, 0.62, 0.89, respectively. The viscous solutions were cast into films and the chloroform was evaporated in air at room temperature. Surprisingly clear and transparent films were thus obtained. The electrical conductivities of polyblend films were determined, using the standard four-probe method. The data are shown in Fig. 4.

This example demonstrates the feasibility of using the soluble conductive polyaniline to manufacture conductive articles of outstanding optical clarity.

### Example 32

Example 31 was repeated, but the host polymer was the conjugated polymer poly(3-octylthiophene) (Neste Oy, M_{w} = 125,000) instead of polystyrene. The weight ratios of polyaniline-DBSA to poly(3-octylthiophene) in the chloroform solutions were 0.032, 0.062, 0.15 and 0.21. The results of electrical conductivity measurements of the polyblend films are also shown in Fig. 4.

### Example 33

Polybutadiene (Aldrich), 1 g, and benzoylperoxide, 20 mg, were dissolved in 10 g of a polyaniline-DBSA solution in xylene, which was prepared according to the method of Example 16, at room temperature under stirring. A homogeneous solution was obtained which was cast onto a glass substrate. The solvent was removed by evaporation in air at room temperature. The final concentration of polyaniline-DBSA complex in the resulting polyblend film was 6% w/w. This film was cured in an oven at 160°C for 20 minutes. A conductive and very elastic polyaniline-DBSA/polybutadiene rubber film was obtained. The film exhibited an electrical conductivity of 3x10⁻⁶ S-cm⁻¹; the conductivity of the film before curing was 1x10⁻⁵ S-cm⁻¹. The conductive elastomer could reversibly deformed to elongations as much as 600 % without fracture.

### Example 34

Example 33 was repeated, but silicone rubber (Dow Corning RTV 738) was used in place of polybutadiene. This elastomer was cured at room temperature after evaporation of the xylene. The final concentration of the polyaniline-DBSA complex in the silicone rubber was 1 % w/w. The conductivity of the elastomer was 1x10⁻⁶ S-cm⁻¹. The above Examples 33 and 34 demonstrate that, with the soluble polyaniline, conductive articles can be manufactured having outstanding elastomeric properties.

### Example 35

The material of Example 2, in 2.66 g quantity, was mixed with 17.7 g of xylene (13% w/w) in an ultrasonic bath. After 2 hours a stable emulsion of the polyaniline-DBSA in xylene was obtained.

### Example 36

Films were prepared of ultra-high molecular weight polyethylene and the polyaniline-DBSA complex, according to the method of Example 12, but in place of the solution prepared according to the method of Example 27, the emulsion of Example 35 was used. The weight ratios of the polyaniline-DBSA complex to the total polymer content were varied from 0.42, 0.50, 0.60 and 0.70. After drying the electrical conductivity of the polyaniline/UHMW PE blend films were determined using the standard four-probe method. The results are given below in Table 11.

**Table 11**

| Electrical Conductivity of UHMW PE Composite Films Containing PANi-DBSA | |
|---|---|
| PANi-DBSA content (%) | Conductivity (S-cm⁻¹) |
| 20.1 | 0.3 |
| 42.0 | 0.1 |
| 60.0 | 1.2 |
| 70.0 | 2.0 |

This experiment shows that polyblend systems with a large content of the conductive polyaniline can be prepared.

### Example 37

The conductive form of polyaniline was prepared as in Example 2. Differential scanning calorimetry (DSC) scans of the material exhibited an exothermal peak at ca. 95°C and an endothermal peak at ca. 150°C. The thermal stability of EB-DBSA complex was examined by thermogravimetric (TG) analysis (Mettler TA3000 system). The complex was stable at temperatures exceeding 270°C. Using a laboratory press at room temperature, the resulting mixture was pressed into a pellet at room temperature. After pumping for 96 hours in dynamic vacuum at room temperature, the electrical conductivity of the pellet of the polyaniline-DBSA complex was measured in a dry box filled with argon, using the standard four-probe method. The resulting conductivity was 26.4 S-cm⁻¹.

Remarkably it was observed that a coherent thin film was obtained by pressing at 160 °C, which is indicative of the plasticizing effect of the functionalized protonic acid. After pumping for 96 hours in dynamic vacuum at room temperature, the electrical conductivity of the film of the polyaniline-DBSA complex was measured in a dry box filled with argon. The resulting conductivity was as high as 92 S-cm⁻¹. This example shows how a fluid phase protonic acid such as DBSA can itself serve as a solvent/plasticizer. The acid can be fluid (liquid or semisolid) at room temperature or at an elevated temperature and achieve the advantages of the invention.

### Example 38

The nonconductive form of polyaniline of Example 1, 0.091 g (0.001 M), was mixed in an Agate mortar and pestle with 0.163 g DBSA ( 0.0005 M) and 0.254 g of powdery linear polyethylene (GR 2755; M_{w}=200,000) in a dry bag filled with nitrogen. The mixture was pressed at 165°C between hot plates for 30 seconds; the 30 second hot-process-ing step was repeated three more times (for a total of four) to assure uniform mixing. Flow and mixing were observed to occur and tough and flexible films were obtained after cooling to room temperature. The weight ratio of the polyaniline-DBSA (DBSA/PhN=0.5) complex to the total polymer was 0.5.

### Example 39

Example 38 was repeated, but the amount of polyethylene was varied such that the weight ratio of the polyaniline-DBSA complex to the total polymer was 0.34, 0.20 and 0.11. Flow and mixing were observed to occur and tough and flexible films were obtained after cooling to room temperature. This example shows that in situations where the acid is fluid and serves as the liquid (solvent) phase one can additionally add a wide range of other polymers and achieve the desired conductivity properties.

### Example 40

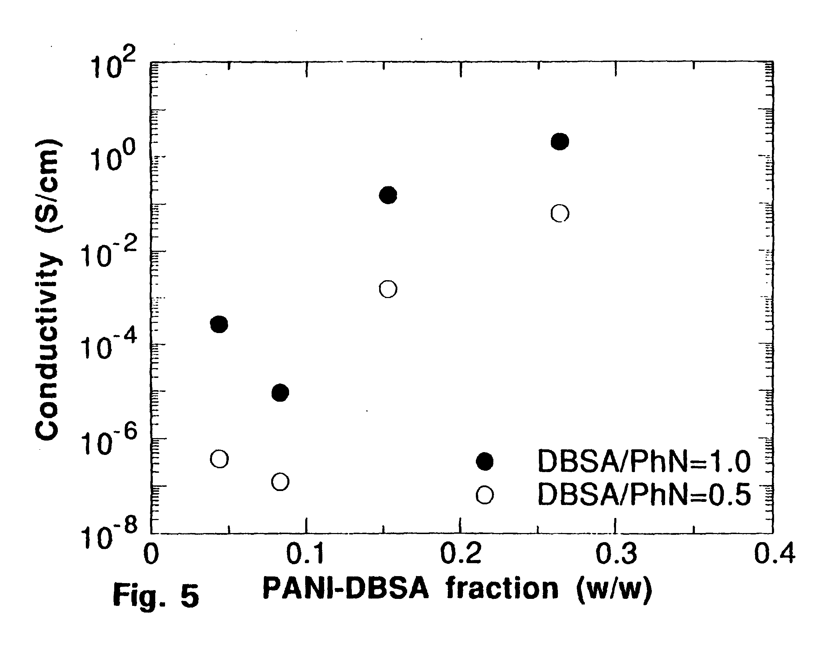

The electrical conductivities of the materials of Examples 38-39 were measured using the standard four-probe method. The results are shown in Figure 5.

These data show that this conductive form of polyaniline can be mixed in the melt with polyolefins to yield materials of excellent electrical and mechanical properties. The Examples 38-39 also show that molten polymers can be used as plasticizing liquids, and that additional amounts of the functionalized protonic acid can increase the conductivity through enhanced miscibility between the conductive polyaniline and polyethylene.

### Example 41

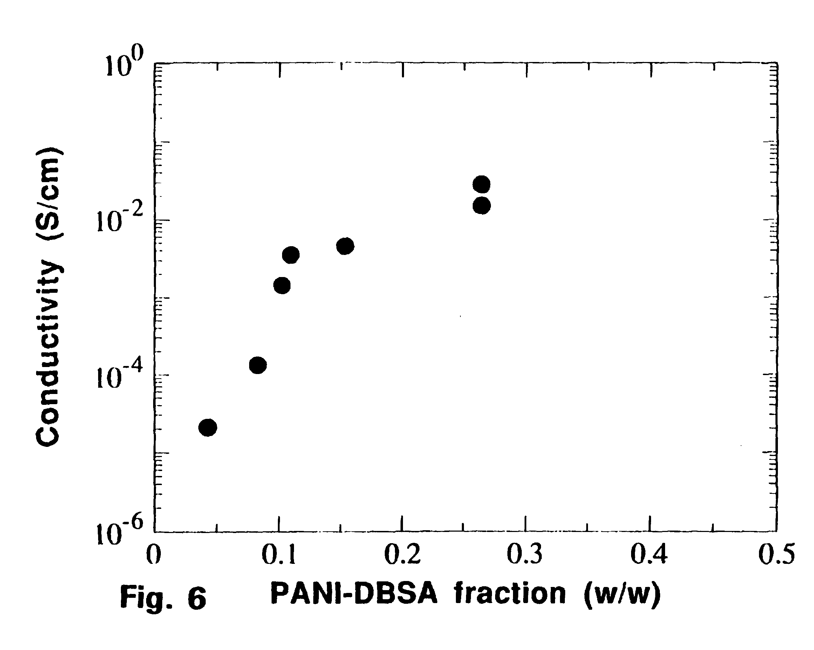

Examples 38 and 39 were repeated, but in place of polyethylene powdery nylon 12 (Polysciences) was used. The mixture was pressed at 175°C between hot plates for 30 seconds and subsequently re-pressed (again for 30 seconds). Flow and mixing were observed to occur and tough and flexible films were obtained after cooling to room temperature. The electrical conductivities of the films were measured using the four-probe method; the results are shown in Figure 6.

This shows that this conductive form of polyaniline can be mixed in the melt with nylons to yield materials of excellent electrical and mechanical properties. It also shows that molten polymers and liquid protonic acids can be used as plasticizing liquids.

### Example 42

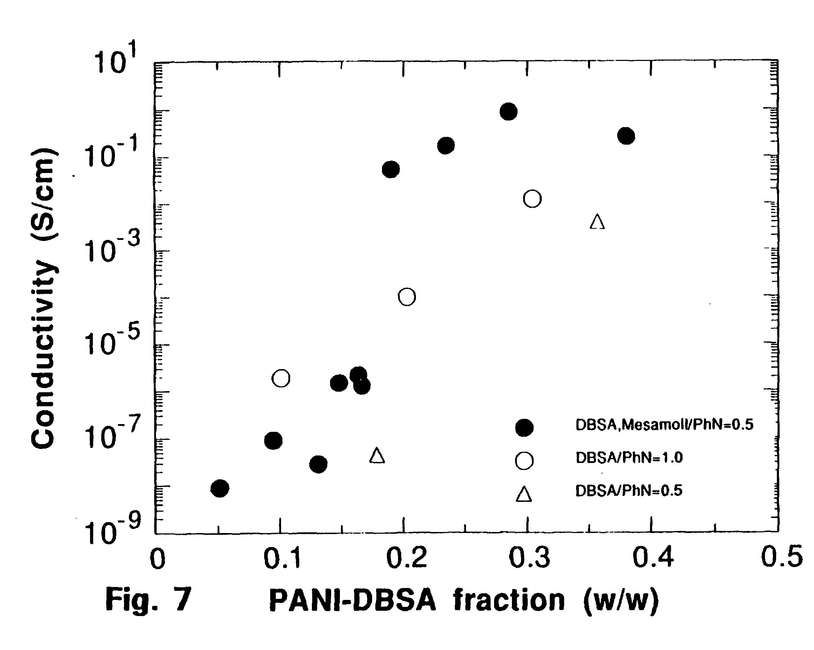

Example 38 and 39 were repeated, but in place of polyethylene poly(vinylchloride) (PVC) power was used. The mixture was pressed at 165°C between hot pates. In separate experiment plasticizer Mesamoll (Bayer) was used instead of additional DBSA. The electrical conductivity of the resulting tough and flexible films were measured using the four-probe method; the results are shown in Figure 7.

Example 42 shows that neutral plasticizers can be used in combination with DBSA as plasticizing liquid for melting processing of PANi polyblends to yield materials of excellent electrical and mechanical properties.

### Example 43

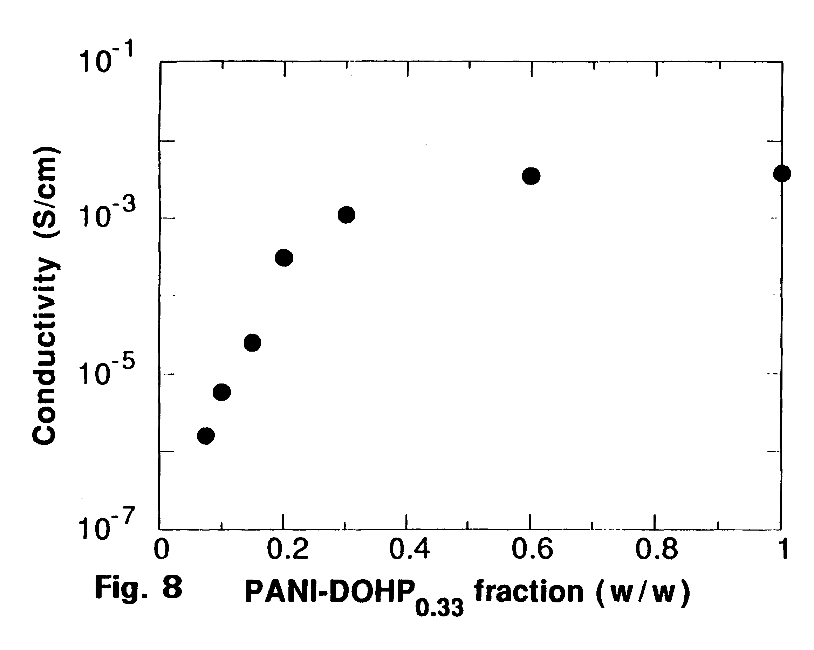

Example 42 was repeated, but in place of DBSA, 0.33 mole DOHP was used per PhN repeat unit. The mixture was pressed at 165°C between hot plates. The electrical conductivity of the resulting tough and flexible films were measured using the four-probe method; the results are shown in Figure 8.

Example 42 shows that phosphates can be used as functionalized protonic acid for rendering PANi conductive and plasticizing and mixing with PVC to yield materials of excellent electrical and mechanical properties.

In some embodiments these materials take advantage of their transparency and/or their coloration to give rise to transparent or colored electrodes. In addition, in some embodiments the transparent or colored electrodes are employed in flexible light-emitting diodes. The following examples relate to these embodiments.

### Example 44

Emeraldine base, 1.092 g, characterized in terms of molecular weight and the like by having an inherent viscosity of 1.2 dL/g when measured at room temperature as a 0.1% w solution in 97% H₂SO₄, (.012M), was mixed with 1.394 g of CSA, (±)-10-camphorsulfonic acid, (Aldrich) using an agate mortar and pestle in inert atmosphere (i.e. in a glove-bag filled with nitrogen gas). The molar ratio of CSA to aniline repeat unit was 0.5. A quantity (1.275 g) of the resulting mixture was placed into 61.0 g of m-cresol, treated in an ultrasonic bath for 48 hours, and subsequently centrifuged. Most of the polyaniline-CSA complex dissolved to give a viscous deep green solution. Minor insoluble solids were removed by decanting. Part of the solution was set aside, weighed, and then cast onto a glass slide. After evaporation of the solvent, a flexible free-standing film was obtained; the film was weighed to calculate the content of the conductive polyaniline complex in said solution. The concentration was determined as 1.94%(w/w).

### Example 45

Example 44 was repeated, but with the CSA/PhN ratio varying over the following values: 0.6,0.7, 0.8, 0.9, 1.0, 1.5, 2.0. To make the polyaniline-CSA solution. 0.138, 0.152, 0.166, 0.180, 0.194, 0.264, 0.334, g of each mixture were added into 10 g of m-cresol to keep the emeraldine content in each solution at 0.0006 M in 10 g m-cresol. Complexes with CSA/PhN molar ratio equal or larger than 0.7 were completely soluble in m-cresol, thus centrifuge separation was not necessary for such solutions. Free-standing polyaniline films were obtained from all those solutions after casting onto glass slides and solvent evaporation. The resulting films were washed by acetone several times. During this process, most of excess CSA was removed from film, as was evident from the results of the compensation procedure. The compensation was done as follows: in each case, a small weighed piece of said free-standing PANi/CSA film was treated by 3% aq. NH₄OH solution for two hours. The resulting neutral PANi (emeraldine base) films were washed with water and acetone. After drying in air, the films were weighed again. From the difference in weight before and after compensation, the content of CSA in the films was calculated as summarized in Table 12. The conductivities of the conducting PANi/CSA films were determined by the usual four probe method, in air, and are also listed in Table 12.

**Table 12**

| Conductivity of Free-Standing Polyaniline-CSA Film | | |
|---|---|---|
| CSA/PhN Ratio | | Conductivity S-cm⁻¹ |
| Initial in Solution | in Film | |
| 0.5 | 0.49 | 230 |
| 0.6 | 0.53 | 163 |
| 0.8 | 0.51 | 168 |
| 0.9 | 0.53 | 138 |
| 1.0 | 0.54 | 158 |
| 1.5 | 0.58 | 143 |
| 2.0 | 0.58 | 154 |

### Example 46

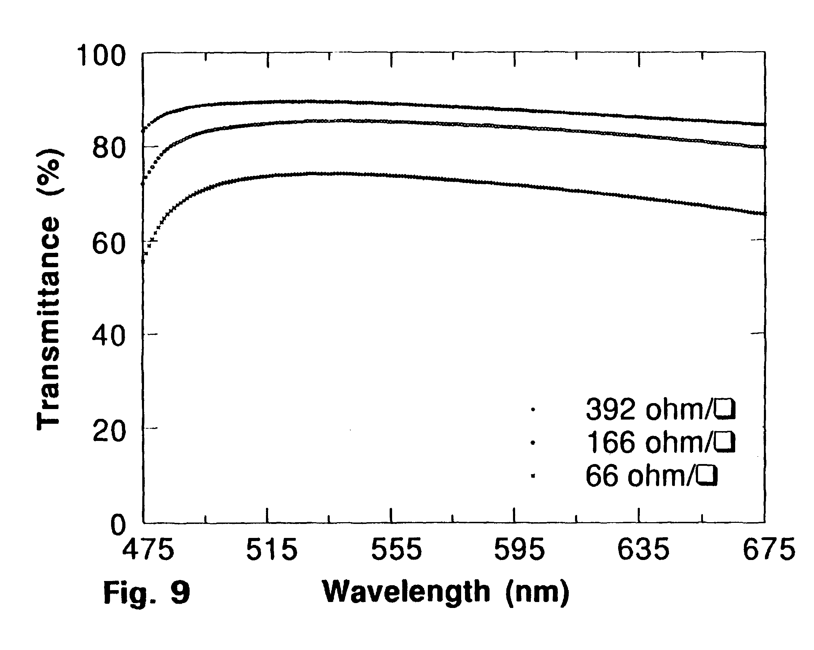

Homogeneous and transparent PANi/CSA thin films were obtained when the solution of Example 44 was spin cast (10000 rpm, 2 min) onto glass or sapphire substrates. The surface resistivity of spin cast PANi/CSA thin film (ca. 0.55 µm) on glass substrate was 166 ohms/square as determined by the four probe method. The surface resistivity of spin cast PANi/CSA thin film (ca. 1.4 µm) on glass substrate was 66 ohms/square as determined by the four probe method. Fig. 9 shows the transmission spectra of the three PANi/CSA films (ca. 0.2 µm thickness, 0.55µm thickness and 1.4 µm thickness) on a glass substrate. In the visible region the transmittance was 70-80% for the 1.4 µm thick film, 75%-85% of the 0.55 µm film and 80%-90% of the 0.2 µm film. This example demonstrates that conductive transparent films of the polyaniline complex can be cast from solution.

### Example 47

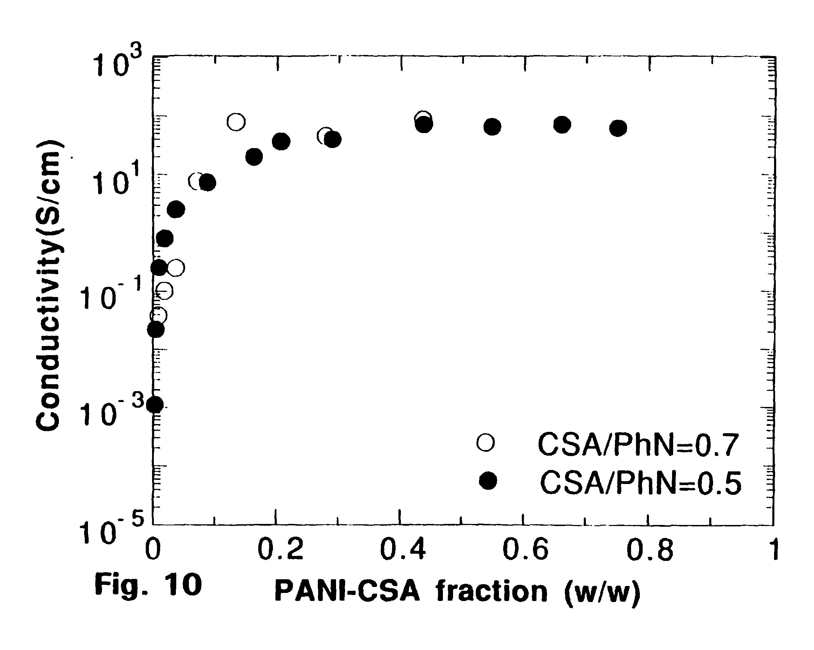

A one (1) gram quantity of solution, prepared as in Example 44, was mixed with one (1) gram of 10%(w/w) solution of poly(methyl methacrylate), PMMA in m-cresol. The resulting homogeneous solution was spin-cast (10000 rpm, 2 min) onto a glass substrate. Subsequently, the substrate was put on a hot plate at 50 °C, in air, to remove the remaining m-cresol from the film. The PANi/CSA complex content was 16.2% w/w (PANi/CSA to total polymer) in the film. Transparent free-standing blend films with said composition were prepared with thickness in the range 20-30 µm by casting the corresponding solution onto a glass slide. Similar experiments were repeated, but the polyaniline-CSA complex content was varied to be 75%, 66%, 54.8, 43.7%, 28.0%, 20.6%, 8.8%, 3.7%, 1.9%, 0.96%, 0.48%, and 0.24%. The surface resistance for the thin films on substrates and the bulk conductivity for the free-standing films were measured using the standard four-probe method; the conductivity results are summarized in Fig. 10.

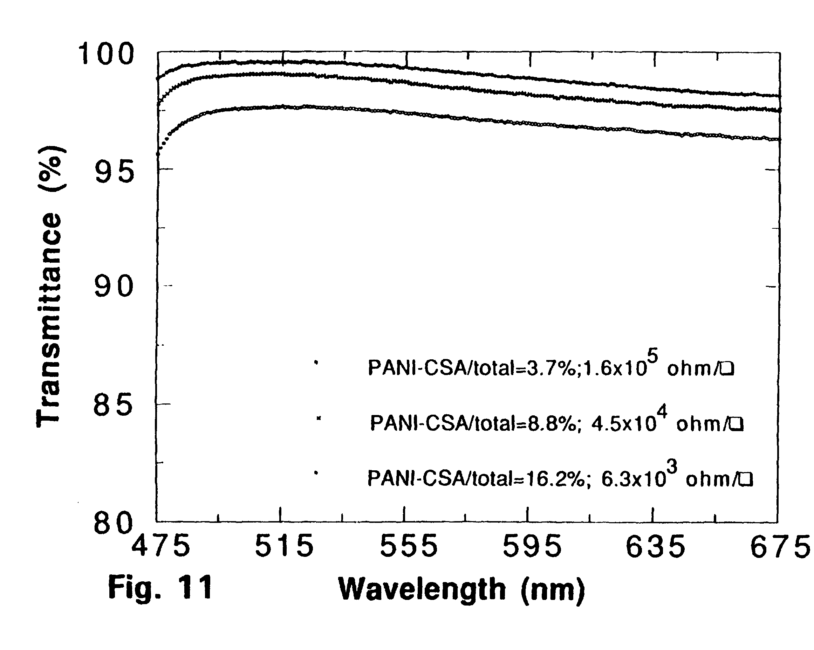

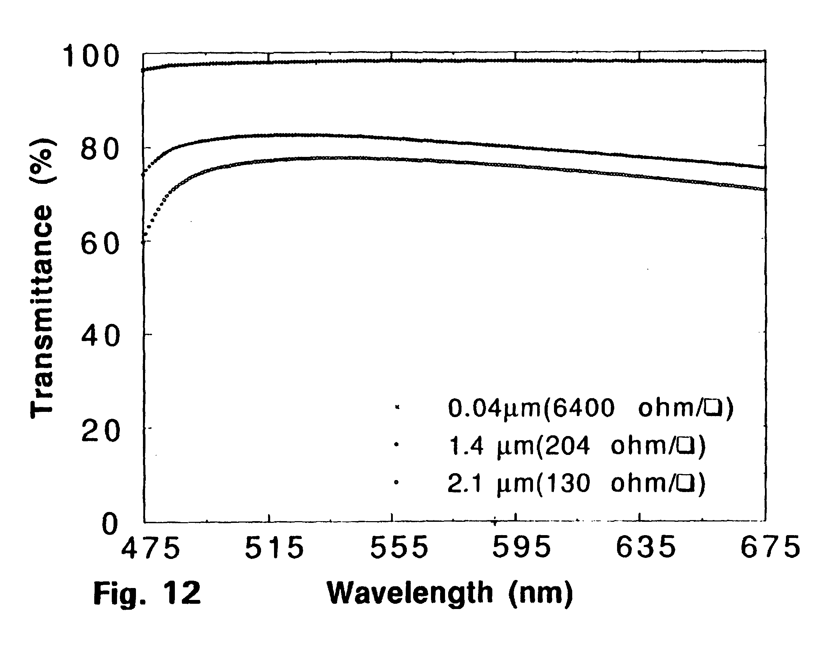

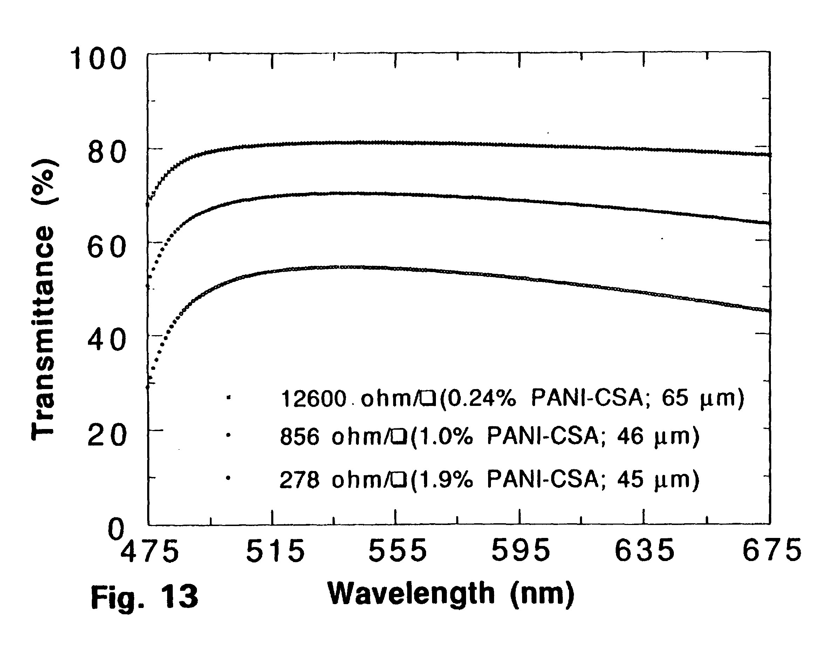

Fig. 11 shows the transmission spectra of the thin spin-cast films for PANi-CSA ratio of 16.2%, 8.8% and 3.7%, respectively. The surface resistance was 6.3x10³, 4.5x10⁴, and 1.6x10⁵ ohms/square, respectively. All of the spin-cast thin films exhibit transmission greater than 90% throughout the visible region of the spectrum. Increasing the thickness of the film leads to a decrease in surface resistance, as expected. Fig. 12 compares the transmission spectra of spin cast (onto glass substrates) films of different thickness with polyaniline-CSA content 20.6%. The thickest of these films (approx. 2.1µm) of polyaniline-CSA complex with PMMA film exhibited excellent transparency in the visible region of the spectrum and a low surface resistance (130 ohms/square). Data for a number of free standing cast films (with thickness around 45-65 µm) are summarized in Fig. 13. This example demonstrates that conductive transparent films of the polyblends containing polyaniline complex at different concentrations in PMMA can be cast from solution.

### Example 48

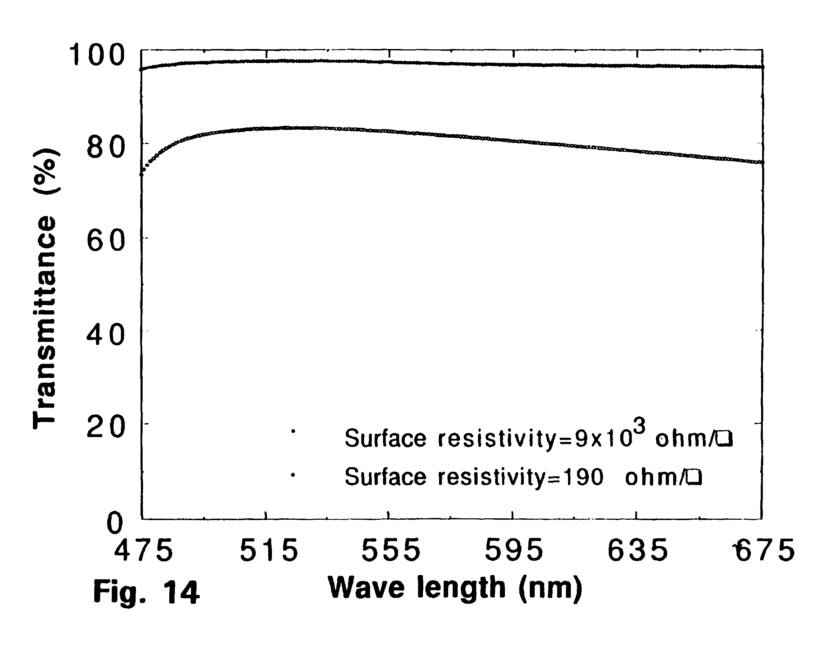

Example 47 was repeated, but with the CSA/aniline ratio fixed at 0.7; the polyaniline-CSA complex content was varied as follows: 43.6%, 27.8%, 13.4%, 7.2%, 3.72%, 1.9% and 0.96%, respectively. The bulk conductivity data for free-standing film are plotted in Fig. 10. Spin cast films exhibit excellent visible light transmission; two representative spectra are shown in Fig. 14. This example demonstrates that conductive transparent films of the polyblends containing polyaniline complex at different concentrations in PMMA can be cast from solution.

### Example 49

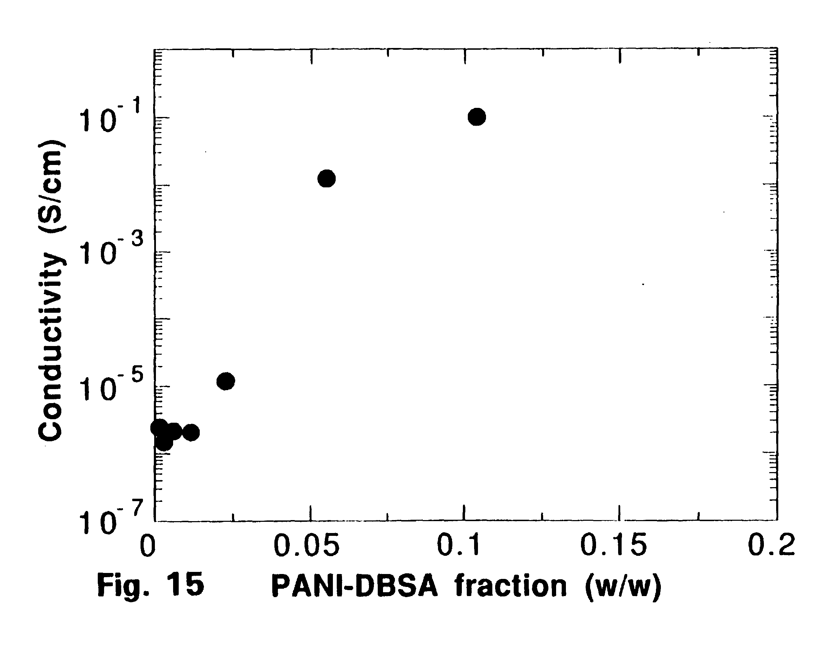

Emeraldine base (2.18 g. 0.024M of PhN) was mixed thoroughly with 3.91 g (0.12 M) of p-dodecylbenzenesulfonic acid (Tokyo Kasei) using an agate mortar and pestle in a glove bag filled with nitrogen. The molar ratio of DESA to PhN repeat unit was 0.5. A solution of polyaniline/DBSA complex in chloroform was prepared by mixing of 0.2 g of the resulting polyaniline/DBSA complex with 0.2 g of additional DBSA and 20 g of chloroform. The mixture was treated in an ultrasonic bath for 24 hours and subsequently centrifuged. Insoluble solids were removed by decanting. The concentration of polyaniline/DBSA complex in the solution was 1.16%(w/w) as determined by weight change before and after removing solvent from a previously weighed solution. A 0.5 gram quantity of the resulting solution was mixed with 0.5 gram of 10%(w/w) solution of poly(methyl methacrylate), PMMA in chloroform. The resulting homogeneous solution was cast onto a glass slide to obtain a transparent freestanding film. The PANi/DBSA complex content in the film was 10.4% w/w (PANi/DBSA to total polymer). Similar experiments were repeated, but the polyaniline-DBSA complex content was varied to be 5.5%, 2.3%, 1.2%, 0.6%, 0.3%, 0.1%. Conductivity data measured by the four probe technique are shown in Fig. 15. All these films exhibit good transparency in the visible region.

### Example 50

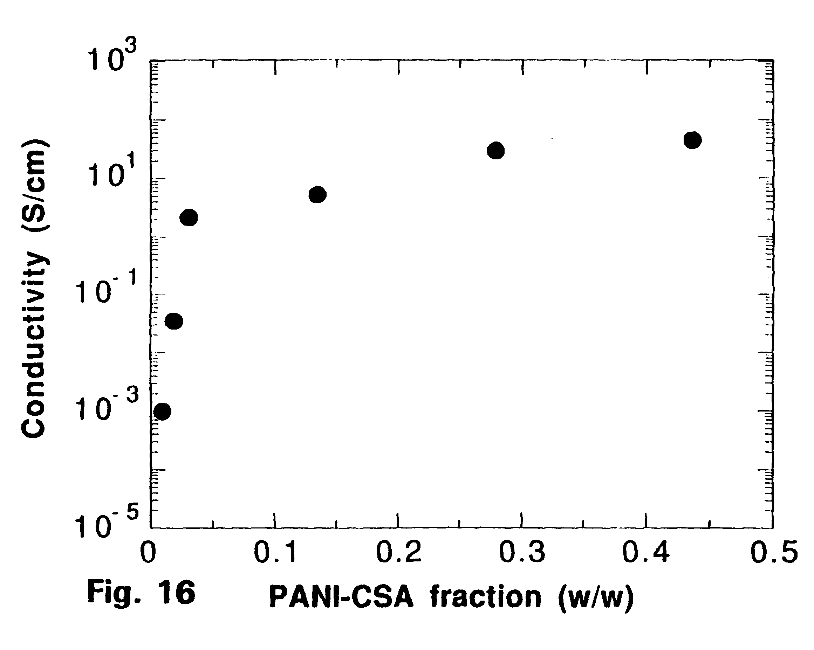

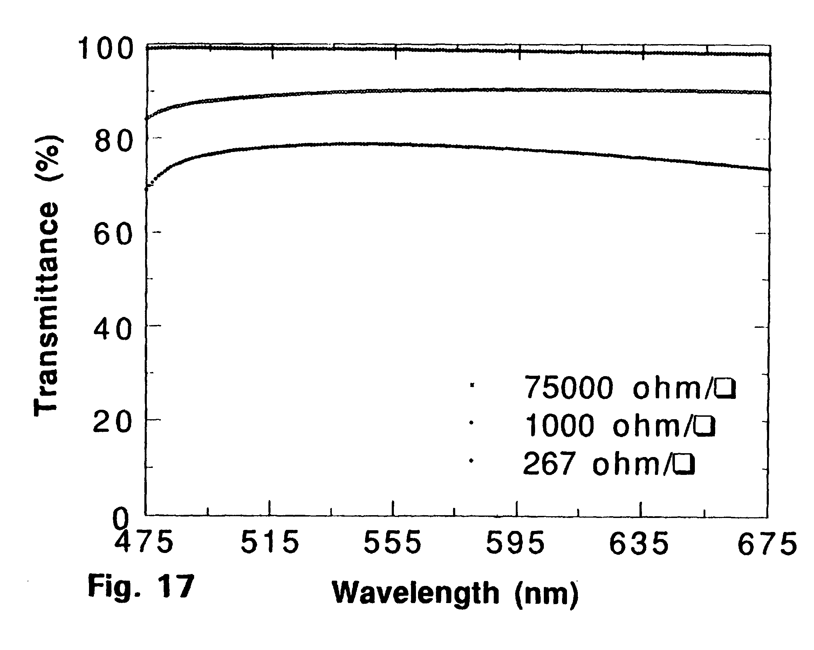

Example 48 was repeated, using polyvinylacetate (PVAc) as the host polymer The initial concentration of PVAc in m-cresol was 5% w/w. The bulk conductivity data are shown in Fig. 16. Spin cast films exhibit excellent visible light transmission; the spectra are shown in Fig. 17. This example demonstrates that conductive transparent films of the polyblends containing polyaniline complex at different concentrations in PVAc can be cast from solution.

### Example 51

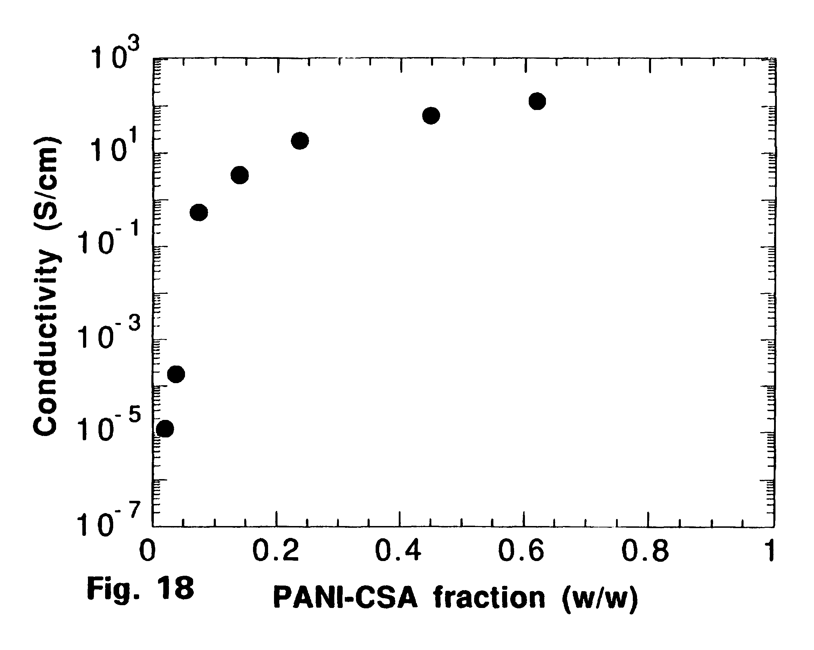

Example 48 was repeated, using a polycarbonate (PC) as the host polymer. The initial concentration of PC in m-cresol was 4.74% w/w. The polyaniline-CSA complex content in the blend films was 62.0%, 44.9%, 23.6%, 14.0%, 7.3%, 3.8% and 2.0%, respectively. The electrical conductivity of resulting transparent free-standing blend films is shown in Fig. 18. This example demonstrates that conductive polyblend films of PANi-CSA with PC can be cast from solution.

### Example 52

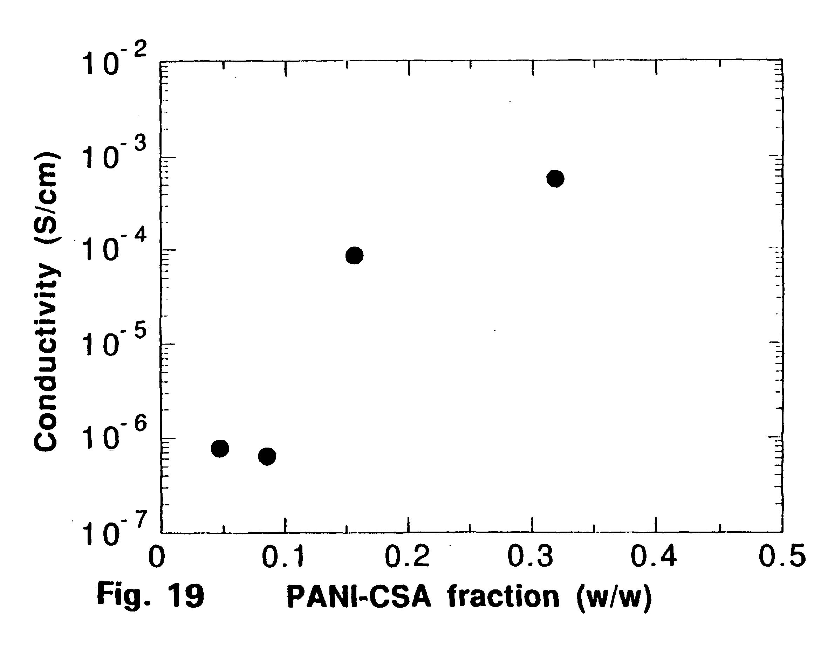

Example 47 was repeated, using poly(acrylonitrile) (PAN) as the host polymer. The PAN and polyaniline-CSA complex were dissolved in dimethylsulfoxide (DMSO) by stirring at room temperature to get solutions with concentrations 2%, 3.7%, respectively. The polyaniline-CSA complex content in resulting blend film was 31.9%, 15.6%, 8.6%, and 4.7%, respectively. The electrical conductivities of resulting free-standing blend films are shown in Fig. 19. The films exhibited excellent transparency in visible region, similar to those shown in Fig. 12 for PMMA blends. This example demonstrates that conductive polyblend films of PANi-CSA with PAN can be cast from solution.

### Example 53

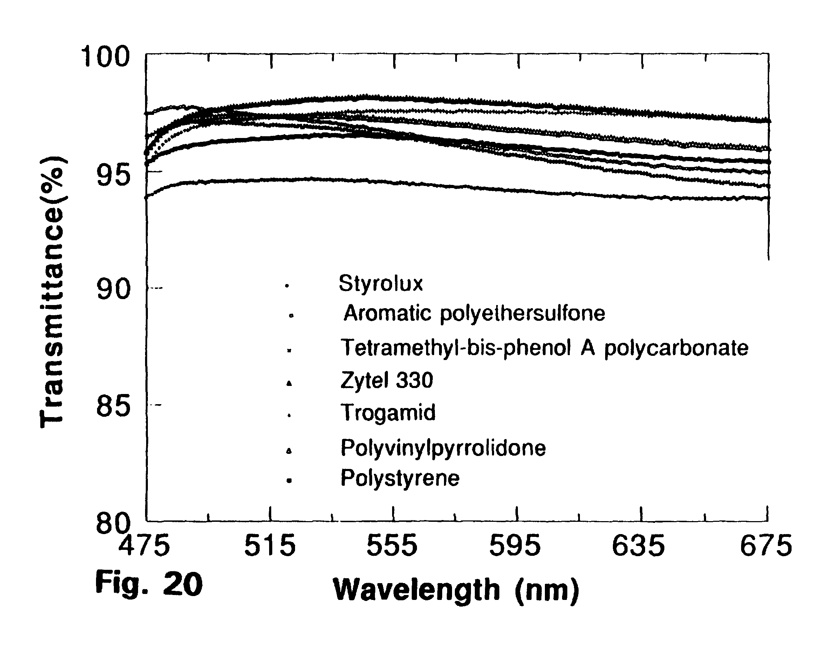

Example 47 was repeated, using Styrolux (a block co-polymer of polystyrene-butadiene; BASF), aromatic polyethersulfone, tetramethyl-bis-phenol A polycarbonate, Zytel 330 (amorphous Nylon; DuPont), Trogamid (amorphous Nylon; Hulls), polyvinylpyrrolidone (Polysciences), polystyrene (Polysciences), poly(styrene-acrilonitrile) (BASF) as host polymers. The polyaniline-CSA complex content in the resulting blend films were 8.8%, 4.6% and 0.96%. For all these polymers, optically transparent films were obtained. The bulk electrical conductivities of free-standing films are listed in Table 13. Spin cast film exhibit similar transmission spectra as shown in Fig. 20. This example demonstrates that conductive transparent films of the polyblends containing polyaniline complex at different concentrations in a wide variety of host polymers can be cast from solution.

**Table 13**

| Conductivity of Blend Films of Polyaniline-CSA Complex with Several Commercial Polymers | | | |
|---|---|---|---|
| Polymer | Conductivity (S-cm⁻¹) | | |
| | 8.8% | 4.6% | 0.96% |
| Styrolux | 6.4 | 2.2 | .02 |
| Aromatic polyether sulfone | 5.7 | 2.8 | .07 |
| tetramethyl-bis-phenyl A polycarbonate | 2.0 | .42 | .43 |
| Zytel 330 | 4.9 | .63 | .01 |
| Trogamid | 4.6 | .73 | .003 |
| polyvinylpyrrolidone | 1.4 | 1.0 | .02 |
| polystyrene | 6.0 | 2.0 | .12 |
| poly(styrene-acrylonitrile) | 6.4 | 2.4 | .14 |

### Example 54

Flexible LEDs were formed using the materials of this invention. Polyaniline films were spin-cast from solution in the conducting emeraldine salt form, for use as the transparent, flexible, hole-injecting electrode, onto a free-standing poly(ethylene terephthalate) (PET) film as substrate. Prior to use as the substrate, the PET free standing film substrate was cleaned by boiling in an acetone/isopropanol mixture and subsequently dried at 80°C for 1 hour.

A polyaniline solution was prepared using the method of Example 44 and spin-coated onto the PET substrate film.

After spin-coating, the PANi/PET structures were dried at 60°C for 12 hours. A layer of poly(methoxyhexyloxyphenylenevinylene) (MEH-PPV) was then deposited onto the PANi surface by spin-coating from a 0.5% (wt/wt) solution of MEH-PPV in xylenes.

No sign of dissolution of the PANi from the MEH-PPV solution could be observed. The two component system was designed so that each component, the PANi-CSA complex and MEH-PPV, were separately soluble; but each was insoluble in the solvent which dissolved the other.

Calcium was used as the electropositive metal to serve as the rectifying and electron-injecting top contact. The calcium was deposited by vacuum evaporation at a pressure below 10⁻⁶ Torr.

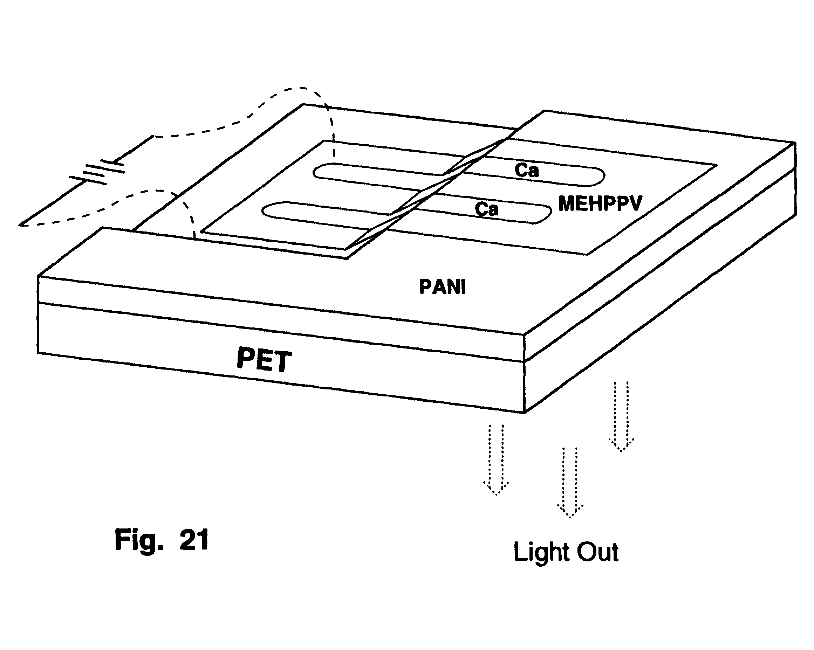

The deposition of the MEH-PPV layer and all physical measurements of the LED devices were carried out in nitrogen atmosphere in a controlled atmosphere dry-box. Contact to PANi was made by a thin, vacuum evaporated gold film. The gold contact was used in the initial studies to make certain that the PANi electrode was not current limiting; however, subsequent experiments have shown that it is also possible to contact the transparent PANi electrode with silver paste or, simply, with an alligator clip. A diagram of the structure of the flexible plastic" LED is shown in Figure 21.

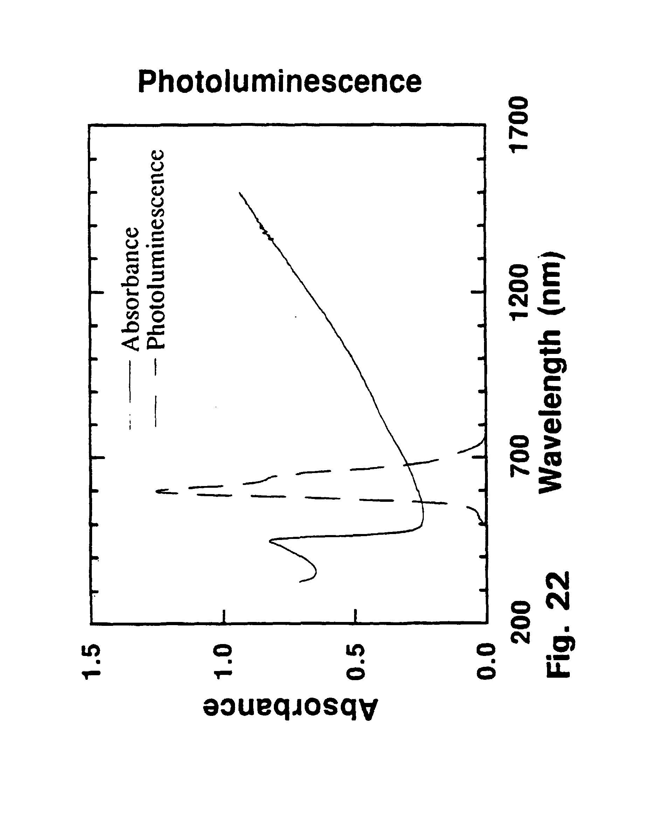

The PANi electrode has a light green color since it has a transmission window extending from about 475 nm into the infrared. The absorption spectrum of the PANi electrode (Figure 22) shows the characteristic features of the emeraldine salt form of polyaniline with a strong absorption peak at 440 nm and a broad absorption band extending into the infrared. The electroluminescence from the semiconducting MEH-PPV active layer falls right in the transmission window between the two principal absorptions of the PANi electrode.

The "plastic" LED is flexible and can be curled and bent (even folding back on itself in a sharp 180° bend) without failing, as would occur with conductors of the art. The robust nature of the four-layer structure clearly proves the excellent mechanical adhesion of the PANi/MEH-PPV heterostructure interfacial contact and the PANi/PET contact (and, in addition, of the Ca/MEH-PPV contact).

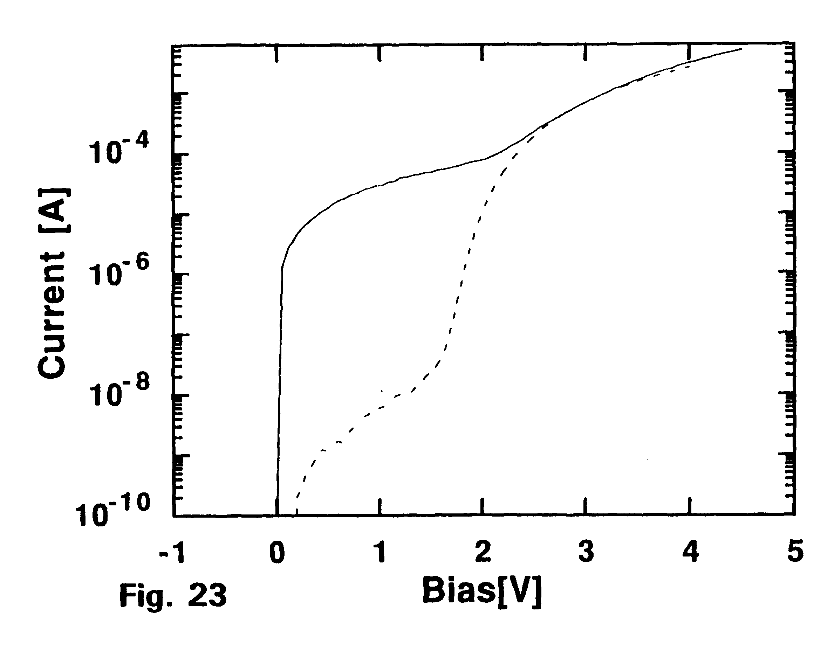

The current-voltage (IV) characteristic (Figure 23) of the device exhibits rectifying behavior. Above 1.8 V, in the voltage range where the LED devices start to emit light, the current through devices utilizing the conducting PANi transparent film as the hole-injecting contact are almost the same as in devices fabricated with ITO as the hole-injecting contact.

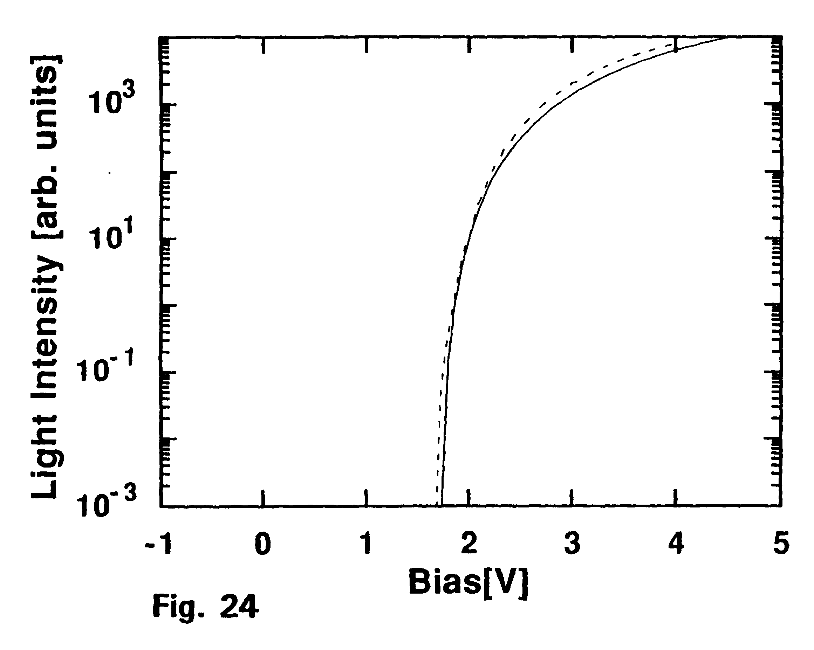

The quantum efficiency of the device of this example is approximately 1% (photons out per electron in). The light emitted by the device is easily visible under ordinary room lighting even at low bias voltages (3-4 volts) (Figure 24).

### Example 55

Transparent conducting films of the PANi-CSA complex used in Example 54 were spin coated with a variety of thicknesses; the thickness and, accordingly, the surface resistance of the PANi/PET electrode can be controlled by varying the spinning speed and/or the concentration of the PANi solution. This also affects the transmittance of the PANi film as can be seen in Figure 9 which shows the transmittance of visible light between 475-675 nm for PANi films with three different thicknesses and, therefore, three different surface resistance values.

The PANi coated PET electrode is mechanically flexible and robust; it can withstand repeated sharp bends back and forth without loss of surface conductance. This is in contrast to ITO coated PET electrodes which are delicate and easily cracked with consequent loss of conductivity.

The conducting PANi film makes an excellent ohmic contact to p-type semiconducting polymers.

### Example 56

A light emitting diode was fabricated on a glass fiber (50 micron diameter) using the following procedure:
Step 1: After cleaning the glass fiber, the fiber was dipped into a solution of polyaniline/CSA in m-cresol (Example 44) to a depth of about five centimeters. After extracting the fiber from the solution, a PANi/CSA film suitable for use as a hole injecting contact was on the surface of the fiber. The PANi film was dried at 60°C for 1 hour.
Step 2: The portion of the glass fiber with the PANi film was then dipped into a solution of MEH-PPV prepared according to Example 54. When dipping the PANi-coated fiber to form the MEH-PPV layer, care was taken to leave a small length of the PANi film exposed to facilitate electrical contact to the PANi hole-injecting electrode.
Step 3: Calcium was used as the electropositive metal to serve as the rectifying and electron-injecting top contact. The calcium was deposited onto the fiber by vacuum evaporation at a pressure below 10⁻⁶ Torr.

The resulting flexible LED on the fiber end can be bent without failing. The current-voltage (I-V) characteristic of the device exhibits rectifying behavior. The quantum efficiency of the device of this example is approximately 1% (photons out per electron in). The light emitted by the device is easily visible under ordinary room lighting even at low bias voltages (3-4 volts).

A special feature of the flexible LED fabricated directly onto a glass fiber is that the light from the LED is guided down the fiber by internal reflection such that a bright emission is evident at the ends of the fiber.

### Example 58

The fiber LED of Example 57 was placed across a metal rod (10 mm diameter) heated at 90°C. The fiber was allowed to heat up and subsequently bent over the rod. The bent LED was cooled to room temperature and retained its curved shape and its light emitting characteristics.

This example illustrates that LEDs supported on thermoplastic substrates (rods, fibers, films, sheets, etc.) can be post-molded by common heat treatment procedures used in the polymer industry.

### Example 59

Adhesive glue was applied to the flexible LED of Example 54. The structure was then affixed to a curved surface while retaining its light emitting characteristics.

This example shows that the flexible LEDs can be used in a variety of applications where attachment to flexibie curved surfaces is critical, such as labels, signs, etc.

### Example 60

Example 54 was repeated, with the electron-injecting calcium contact replaced by polyquinoline, a semiconducting polymer which has been characterized as n-type. The polyquinoline film was spun from solution in formic acid (1% polyquiniline by weight). The electrical contact to the polyquinoline was made with a gold film vapor deposited onto the polyquinoline layer.

Since MEH-PPV has been characterized as a p-type polymer, the resulting structure forms a pn heterojunction. The all-polymer pn heterojunction was electrically characterized as a rectifying diode; rectification ratio 10³ at 5 volts bias, turn-on voltage of 2 volts, and forward resistance (in the linear regime) of 200 ohms.

Light emission was observed at under forward bias at voltages in excess of 60 volts.

Examples 54-60 illustrate in specific embodiemtns the general aspect of this invention of prividing flexible LEDs. These flexible LEDs include the following layers in their structure, all of which are flexible--that is, capable of being bent by at least 15° without fracturing. Typically, but optionally, they include a solid flexible transparent polymer support. This can be selected broadly from any flexible polymer such as poly(ester), poly(olefin), poly(aramide), poly(acrylate), methacrylate, poly(carbonate), or the like. The function of this support is to add structural body to the LED. This support is not conductive. In Figure 21, this layer is shown as "PET." In cases where the other layers of the LED are themselves robust, this support layer could be omitted. If present, the layer can be of any thickness. The next layer is the conducting hole-injecting electrode. This layer includes a PANi material as described herein. It can be PANi alone or in admixture with other polymers. The layer should have an low resistance--i.e., less than 300 ohms per square and preferably less than 100 ohms per square. These resistances are generally achieved with thicknesses of from about 50 mm to a few (up to 10) microns. Thicker or thinner layers can be used if the desired low resistance is achieved. This layer can be cast or otherwise formed as described hereinabove.

An electrical contact is made to the PANi layer. We have used gold but any method of establishing electrical contact will work.

The third layer in the LED structure is the electroluminescent layer made up of conjugated polymer. The conjugated polymers used herein include soluble conjugated polymers known in the art. These include, for example, poly(2-methoxy,5-(2'-ethyl-hexyloxy)-p-phenylenevinylene) or "MEH-PPV", P3ATs, poly(3-alkylthiophenes) (where alkyl is from 6 to 16 carbons), such as poly(2,5-dimethoxy-p-phenylene vinylene)-"PDMPV", and poly(2,5-thienylenevinylene); poly(phenylenevinylene) or "PPV" and alkoxy derivatives thereof; and polyanilines.

The conjugated polymer can be deposited or cast directly from solution. The solvent employed is one which will dissolve the polymer and not interfere with its subsequent deposition. It should also be selected to not dissolve the PANi layer already laid down.

Typically, organic solvents are used for the conjugated polymer solution. These can include halohydrocarbons such as methylene chloride, chloroform, and carbon tetrachloride, aromatic hydrocarbons such as xylene, benzene, toluene, other hydrocarbons such as decaline, and the like. Mixed solvents can be used, as well. Polar solvents such as water, acetone, acids and the like may be suitable. These are merely a representative exemplification and the solvent can be selected broadly from materials meeting the criteria set forth above.

When depositing the conjugated polymer on the PANi layer, the solution can be relatively dilute, such as from 0.1 to 20% w in concentration, especially 0.2 to 5% w. Film thicknesses of 50-400 and 100-200 nm are used.

In some embodiments, the conjugated polymer is present in admixture with a carrier polymer.

The criteria for the selection of the carrier polymer are as follows. The material should allow for the formation of mechanically coherent electroluminescent films, at low concentrations, and remain stable in solvents that are capable of dispersing, or dissolving the conjugated polymers for forming the final film. Low concentrations of carrier polymer are preferred in order to minimize processing difficulties, i.e., excessively high viscosity or the formation of gross inhomogeneities; however the concentration of the carrier should be high enough to allow for formation of coherent structures. Preferred carrier polymers are flexible chain polymers, such as polyethylene, isotactic polypropylene, polyethylene oxide, polystyrene, and the like. Under appropriate conditions, which can be readily determined by those skilled in the art, these macromolecular materials enable the formation of coherent structures from a wide variety of liquids, including water, acids, and numerous polar and nonpolar organic solvents.

Selection of the carrier polymer is made primarily on the basis of compatibility of the conjugated polymer, as well as with the solvent or solvents used.

The initial concentration of the carrier polymer generally is selected above 0.1% by volume, and more preferably above about 0.75% by volume. On the other hand, it is not desirable to select carrier polymer concentrations exceeding 90% by volume, because this has a diluting effect on the final conjugated polymer composite product. More preferably, the concentration of the carrier polymer in the solution is below 50% by volume.

The solvent system for depositing conjugated polymer and carrier polymer should also be one and will not interfere with the previous layers or the subsequent structure formation process.

### The Electron Injecting Contact

The final layer of the LED structure which is located on the other side of the conjugated polymer film from the PANi layer is an electron-injecting contact. This is fabricated from a low work function metal or alloy (a low work function material has a work function below 4.3. Typical materials include indium, calcium, barium and magnesium, with calcium being a particularly good material. These electrodes are applied by using methods well-know to the art (e.g. evaporated, sputtered, or electron-beam evaporation) and acting as the rectifying contact in the diode structure.

## Claims

1. A conductive polymeric composition comprising:
(i) an organic substrate selected from organic solvent, bulk polymer and mixtures thereof, said substrate being fluid or able to be rendered fluid by melting and having a bulk conductivity of less than 10⁻⁸ S-cm⁻¹ and a dielectric constant, at room temperature, below 22;
(ii) polyaniline of weight average molecular weight above 10000 daltons wherein the aniline repeat units are N-unsubstituted; in admixture with
(iii) an effective protonating amount of a protonic acid, said protonic acid including a counter-ion that is functionalized so as to be soluble in the substrate, said acid forming a complex with the polyaniline having a conductivity greater than about 10⁻³ S-cm⁻¹, and being of the formula:
A-R₁ VI
wherein:
A is sulfonic acid, phosphonic acid, hydrogen sulfate, or hydrogen phosphate;
and R₁ is 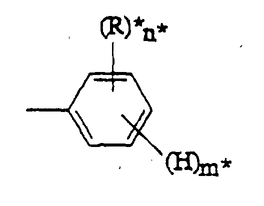
wherein
m* is 4 and n* is 1 and R* is alkyl, alkenyl or alkoxy, having from 2 to 14 carbon atoms or alkyl substituted with one or more carboxylic acid, halogen, nitro, cyano or epoxy moieties;
or A is HOSO₂- and R₁ is selected from the group consisting of (L,D)-10-camphor-, O-anisidine-5-, hydroxybenzene-, 2-hydroxy-4-methoxy-benzophenone-, dinonylnaphthalene-, 4-morpholineethane-, and 2-{[tris(hydroxymethyl)methyl]amino}-1-ethane-;
or A is hydrogen phosphate and R₁ is bis(2-ethyl hexyl)
or A-R₁ is diphenyl hydrogen phosphate
said conductive polymeric composition, if solid, having a microstructure comprising a continuous phase comprising the polyaniline and the protonic acid with its functionalized counter-ion.

2. The conductive polymeric composition of claim 1 wherein the substrate comprises a solvent in which the functionalized counter-ion is soluble.

3. The conductive polymeric composition of claim 1 wherein the substrate comprises a bulk polymer with which the functionalized counter-ion is soluble.

4. The conductive polymeric composition of claim 1 wherein the substrate comprises a bulk polymer and a solvent, with both of which the functionalized counter-ion is soluble.

5. A conductive polymeric composition of claim 1 comprising at least about 10% by weight of substrate and being a solid having a microstructure comprising a continuous phase comprising the polyaniline and the protonic acid with said functionalized counter-ion.

6. The conductive polymeric composition of claim 1 comprising sufficient polyaniline and functionalized protonic acid to provide a protonated polyaniline having a conductivity of at least about 10⁻¹ S-cm⁻¹.

7. The conductive polymeric composition of claim 1 comprising sufficient polyaniline and functionalized protonic acid to provide a protonated polyaniline having a conductivity of at least about 3 x 10² S-cm⁻¹.

8. The conductive polymeric composition of claim 1 wherein the polyaniline is polyaniline having a weight average molecular weight of greater than about 10,000 prepared by polymerizing an aniline of formula 1: 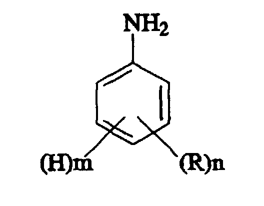 wherein:
n is an integer from 0 to 4;
m is an integer from 1 to 5 with the proviso that the sum of n and m is 5;
R is the same or different at each occurrence and is alkyl, alkenyl, alkoxy, cycloalkyl, cycloalkenyl, alkanoyl, alkylthio, aryloxy, alkylthioalkyl, alkylaryl, arylalkyl, alkylsulfinyl, alkoxyalkyl, alkylsulfonyl, aryl, arylthio, arylsulfinyl, alkoxycarbonyl, arylsulfonyl, carboxylic acid, halogen, cyano, or alkyl substituted with one or more sulfonic acid, carboxylic acid, halogen, nitro, cyano or epoxy moieties; or any two R substituents taken together are an alkylene or alkenylene group completing a 3, 4, 5, 6 or 7-membered aromatic or alicyclic carbon ring, which ring may include one or more divalent heteroatoms of nitrogen, sulfur, sulfinyl, sulfonyl or oxygen.

9. The conductive polymeric composition of claim 8 wherein m is equal to 5 and n is O such that the aniline is unsubstituted aniline.

10. The conductive polymeric composition of claim 1 comprising polyaniline plus dodecylbenzenesulfonic acid which forms a complex with the polyaniline in an amount of from 5 to 95 weight percent, having a conductivity equal to or greater than about 10⁻⁸ S-cm⁻¹.

11. The conductive polymeric composition of claim 1 comprising a plasticizer selected from the group consisting of 4-hexyloxyphenol, 3-pentadecylphenol, nonylphenol, 4-dodecylresorcinol, 4-(tert-octyl)phenol, 2,6-di-tert-butyl-4-methylphenol, 3,4-dimethylphenol, 2,6-dimethylphenol, methyl p-toluenesulfonate, ethyl p-toluenesulfonate, n-hexyl p-toluenesulfonate, ethyldodecylbenzenesulfonic acid isopropylamine alkylaryl sulfonate, 1-dodecanol, 1-tridecanol, 1-docosanol, ethoxylates of the chemical formula CH₃(CH₂)ₓCH₂(OCH₂CH₂)ₙOH, where x=10-14, n=1.3; x=6.8, n=1.0; x=10-12, n=3; x=6-8, n=2; poly(oxy-1,2-ethanediyl), alpha(nonylphenoxy)-ω-hydroxy and sulfated alkyl alcohol ethoxylate ammonium salt.

12. The conductive polymeric composition of claim 1 wherein the substrate comprises molten or liquid oligomer or polymer.

13. The conductive polymeric composition of claim 12 wherein the substrate additionally comprises a liquid solvent and/or a plasticizer.

14. The conductive polymeric composition of claim 13 wherein said solvent is an organic solvent.

15. The conductive polymeric composition of claim 14 wherein said solvent has a dielectric constant smaller than about 22 and wherein said solvent is selected from the group consisting of alkanes and alkenes having from about 5 to about 12 carbon atoms, mineral oil; aromatics, halogenated aromatics, halogenated alkanes, and aliphatic alcohols, alkyl ethers and ketones having from 4 to about 12 carbon atoms, cycloalkanes, cycloalkenes, carbon tetrachloride, carbon disulfide, chloroform, bromoform, dichloromethane, morpholine, aniline, alkylbenzenes, xylene, toluene, decahydronaphthalene, styrene, benzyl alcohol, naphthalene, phenols, and cresols.

16. The conductive polymeric composition of claim 13 wherein said plasticizer is selected from the group consisting of 4-hexyloxyphenol, 3-pentadecylphenol, nonylphenol, 4-dodecylresorcinol, 4-(tert-octyl)phenol, 26-di-tert-butyl-4-methylphenol, 3,4-dimethylphenol, 2,6-dimethylphenol, methyl p-toluenesulfonate, ethyl p-toluenesulfonate, n-hexyl p-toluenesulfonate, ethyldodecylbenzenesulfonic acid isopropylamine alkylaryl sulfonate, 1-dodecanol, 1-tridecanol, 1-docosanol, ethoxylates of the chemical formula CH₃(CH₂)ₓCH₂(OCH₂CH₂)ₙOH, where x=10-14, n=1.3; x=6.8, n=1.0; x=10-12, n=3; x=6-8, n=2; poly(oxy-1,2-ethanediyl), alpha(nonylphenoxy)-ω-hydroxy and sulfated alkyl alcohol ethoxylate ammonium salt.

17. The composition of claim 3 wherein said polymer is selected from the group comprising polyethylenes, isotactic polypropylene, polystyrene, poly(ethylvinylacetate), polybutadiene, polyisoprene, ethylene-vinylene copolymers, poly(vinylchloride), ethylene-propylene copolymers, polysiloxane, polysulfone, polycarbonates, poly(ethylene-terephthalate), homo- and copolymers of acrylonitrile, poly(butyleneterephthalate), nylon 12, nylon 8, nylon 6, nylon 6.6, nylon 4.6, amorphous nylons, poly(vinylacetate), poly(vinylbutyral) and poly(vinyl pyrrolidone).

18. The conductive polymeric composition of claim 12 said composition being solidifiable into a transparent conductor having a conductivity greater than about 10⁻⁸ S-cm⁻¹ and an integrated transmittance of more than 60% over the spectral range of 485 to 675 nm.

19. The conductive polymeric composition of claim 18 wherein the substrate comprises molten or liquid oligomer or polymer.

20. The conductive polymeric composition of claim 18 wherein the substrate comprises a liquid solvent and/or a plasticizer.

21. The conductive polymeric composition of claim 18 wherein the substrate comprises solvent plus molten or liquid oligomer or polymer.

22. The conductive polymeric composition of claim 21 wherein said solvent is selected from the group consisting of alkanes and alkenes having from about 5 to about 12 carbon atoms, mineral oil, aromatics, halogenated aromatics, halogenated alkanes, and aliphatic alcohols, alkyl ethers and ketones having from 4 to about 12 carbon atoms, cycloalkanes, cydoalkenes, carbon tetrachloride, carbon disulfide, chloroform, bromoform, dichloromethane, morpholine, aniline, alkylbenzenes, xylene, toluene, decahydronaphthalene, styrene, naphthalene, phenols, cresols, benzyl alcohol, epoxies, and acrylates.

23. The conductive polymeric composition of claim 18 wherein the functionalized protonic acid is a liquid having a dielectric constant equal to or smaller than about 22 and wherein said protonic acid serves as substrate as well.

24. A conductive polymeric material of any one of claims 1 to 18 comprising polyaniline and a functionalized protonic acid, which forms a complex with the polyaniline, having a conductivity equal to or greater than about 10⁻⁶ S-cm⁻¹ and an integrated transmittance of more than 60% over the spectral range of from 485 to 675 nm.

25. The conductive polymeric composition of claim 1 having a conductivity greater than about 10⁻⁸ S-cm⁻¹ and an integrated transmittance of more than 60% over the spectral range of from 485 to 675 nm.

26. The conductive polymer composition of claim 25 having a transmittance of more that 90% in the spectral range from 475 to 675 nm.

27. The conductive polymer composition of claim 26 having a conductivity of at least 10 S-cm⁻¹ and comprising polyaniline and (L,D)-10-camphorsulfonic acid.

28. A method of forming a conductive polymeric article from a composition as claimed in any one of Cls 1 to 27 which compromises the steps of:
a. forming a solution comprising polyaniline, a substrate including an organic liquid solvent that has a dielectric constant below 22 and optionally a substrate polymer having a conductivity of less than 10⁻⁸ S-cm⁻¹ and a functionalized protonic acid soluble in said solvent and said optional polymer; and
b. removing all or a portion of said solvent from said solution after or concurrent with shaping the solution into the desired article.

29. A method of forming a conductive polymeric article from a composition as claimed in any one of Cls 1 to 27 which compromises the steps of:
a. forming a solution comprising polyaniline, a liquid substrate of organic liquid monomers that has a dielectric constant below 22 and a functionalized protonic acid soluble in said substrate; and
b. polymerizing the monomers in said solution, after or concurrent with shaping the solution into the desired article.

30. A method of forming a conductive polymeric article from a solution which is a composition as claimed in any one of claims 1 to 27 which compromises the steps of:
a. forming a solution comprising polyaniline, a solvent that has a dielectric constant below 22 and a functionalized protonic acid compatible with the solvent and substrate polymers and one or more bulk substrate polymers; and
b. removing all or a portion of said solvent from said solution, thereby giving rise to the conductive polymeric article.

31. A method of forming from a composition as claimed in any one of claims 1 to 27 a solid conductive polymeric article having a nonconductive substrate polymer which compromises the steps of:
a. forming a solution comprising polyaniline, organic liquid monomer precursor to said substrate polymer, and a functionalized protonic acid solute compatible with said monomer; and
b. polymerizing the monomer to yield the solid article.

32. A method of forming from a composition as claimed in any one of claims 1 to 27 a conductive article of conductive polyaniline with substrate by:
a. forming a melt comprising polyaniline, and a functionalized protonic acid solute intimately admixed in a molten polymer substrate selected from the group consisting of thermoplastic polymers; and
b. solidifying said melt.

33. A light-emitting diode comprising a transparent electrode comprising the material of any one of claims 24 to 27.

34. An electrically conductive article comprising the material of any one of claims 1 to 11,24 to 27 and 17 selected from the group consisting of fibers, rods, profiles, films, coatings, membranes, containers, casings, and uses thereof.

35. An electrically conductive liquid comprising the material of any one of claims 12 to 16 and 18 to 23 selected from the group consisting of glues, adhesives, inks, paints, sprays, oils, pastes and waxes, and uses thereof.

36. A flexible light-emitting diode comprising a conducting hole-injecting electrode comprising a conductive polymeric material of claim 24 and an electroluminescent layer comprising a flexible conjugated polymer.

37. The flexible light-emitting diode of claim 36 additionally comprising a electron-injecting contact having a work function below 4.3.

38. The flexible light-emitting diode of claim 37 additionally comprising a flexible polymer support in contact with the conducting hole-injecting electrode.

## Patentansprüche

1. Leitfähige polymere Zusammensetzung, umfassend
(i) ein organisches Substrat, gewählt aus organischem Lösungsmittel, Massenpolymer und Mischungen davon, wobei das Substrat fluid ist oder in der Lage ist, durch Schmelzen fluid gemacht zu werden und eine Leitfähigkeit in der Masse von weniger als 10⁻⁸ S-cm⁻¹ und eine dielektrische Konstante bei Raumtemperatur unterhalb 22 aufweist;
(ii) Polyanilin mit einem gewichtsmittleren Molekulargewicht über 10 000 Dalton, wobei die Anilin-Wiederholungseinheiten N-unsubstituiert sind; in Vermischung mit
(iii) einer wirksamen protonierenden Menge einer protonischen Säure, wobei die protonische Säure ein Gegenion einschließt, welches so funktionalisiert ist, daß es in dem Substrat löslich ist, wobei die Säure einen Komplex mit dem Polyanilin bildet, welcher eine Leitfähigkeit von über etwa 10⁻³ S-cm⁻¹ aufweist und von folgender Formel ist:
A - R₁ VI
worin:
A Sulfonsäure, Phosphonsäure, Hydrogensulfat oder Hydrogenphosphat ist;
und R₁ 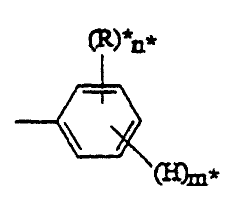
ist, worin
m* 4 ist und n* 1 ist, und R* Alkyl, Alkenyl oder Alkoxy mit 2 bis 14 Kohlenstoffatomen oder mit einem oder mehreren von Carbonsäure-, Halogen-, Nitro-, Cyano- oder Epoxyresten substituiertes Alkyl ist;
oder A HOSO₂- ist und R₁ aus der Gruppe gewählt ist, bestehend aus (L,D)-10-Campher-, O-Anisidin-5-, Hydroxybenzol-, 2-Hydroxy-4-methoxybenzophenon-, Dinonylnaphthalin-, 4-Morpholinethan- und 2-{[Tris(hydroxymethyl)-methyl]amino}-1-ethan-;
oder A Hydrogenphosphat ist und R₁ Bis(2-ethylhexyl) ist;
oder A-R₁ Diphenylhydrogenphosphat ist,
wobei die leitfähige polymere Zusammensetzung, sofern sie fest ist, eine Mikrostruktur aufweist, die eine kontinuierliche Phase umfaßt, umfassend das Polyanilin und die protonische Säure mit ihrem funktionalisierten Gegenion.

2. Leitfähige polymere Zusammensetzung gemäß Anspruch 1, wobei das Substrat ein Lösungsmittel umfaßt, in dem das funktionalisierte Gegenion löslich ist.

3. Leifähige polymere Zusammensetzung gemäß Anspruch 1, wobei das Substrat ein Massenpolymer umfaßt, mit dem das funktionalisierte Gegenion löslich ist.

4. Leitfähige polymere Zusammensetzung gemäß Anspruch 1, wobei das Substrat ein Massepolymer und ein Lösungsmittel umfaßt, wobei mit beiden das funktionalisierte Gegenion löslich ist.

5. Leitfähige polymere Zusammensetzung gemäß Anspruch 1, umfassend mindestens etwa 10 Gew.-% Substrat, und die ein Feststoff mit einer Mikrostruktur ist, umfassend eine kontinuierliche Phase, die das Polyanilin und die protonische Säure mit dem funktionalisierten Gegenion umfaßt.

6. Leitfähige polymere Zusammensetzung gemäß Anspruch 1, umfassend ausreichend Polyanilin und funktionalisierte protonische Säure, um ein protoniertes Polyanilin mit einer Leitfähigkeit von mindestens etwa 10⁻¹ S-cm⁻¹ bereitzustellen.

7. Leitfähige polymere Zusammensetzung gemäß Anspruch 1, umfassend ausreichend Polyanilin und funktionalisierte Protonensäure, um ein protoniertes Polyanilin mit einer Leitfähigkeit von mindestens etwa 3 x 10² S-cm⁻¹ bereitzustellen.

8. Leitfähige polymere Zusammensetzung gemäß Anspruch 1, wobei das Polyanilin Polyanilin mit einem gewichtsmittleren Molekulargewicht von mehr als etwa 10 000 ist, hergestellt durch Polymerisieren eines Anilins der Formel 1: 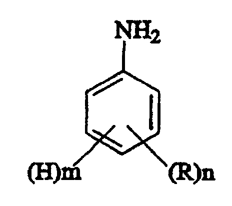 worin:
n eine ganze Zahl von 0 bis 4 ist;
m eine ganze Zahl von 1 bis 5 ist, mit der Maßgabe, daß die Summe von n und m 5 ist;
R gleich oder verschieden bei jedem Auftreten ist und Alkyl, Alkenyl, Alkoxy, Cycloalkyl, Cycloalkenyl, Alkanoyl, Alkylthio, Aryloxy, Alkylthioalkyl, Alkylaryl, Arylalkyl, Alkylsutfinyl, Alkoxyalkyl, Alkylsulfonyl, Aryl, Arylthio, Arylsulfinyl, Alkoxycarbonyl, Arylsulfonyl, Carbonsäure, Halogen, Cyano oder Alkyl, substituiert mit einem oder mehreren von Sulfonsäure-, Carbonsäure-, Halogen-, Nitro-, Cyano- oder Epoxyresten, ist; oder jedwede zwei R-Substituenten zusammengenommen eine Alkylen- oder Alkenylengruppe, die einen 3-, 4-, 5-, 6- oder 7-gliedrigen aromatischen oder alicyclischen Kohlenstoffring vervollständigt, bilden, wobei der Ring ein oder mehrere zweiwertige Heteroatome von Stickstoff, Schwefel, Sulfinyl, Sulfonyl oder Sauerstoff einschließen kann.

9. Leitfähige polymere Zusammensetzung gemäß Anspruch 8, wobei m gleich 5 ist und n 0 ist, so daß das Anilin unsubstituiertes Anilin ist.

10. Leitfähige polymere Zusammensetzung gemäß Anspruch 1, umfassend Polyanilin plus Dodecylbenzolsulfonsäure, welches einen Komplex mit dem Polyanilin in einer Menge von 5 bis 95 Gew.-% bildet, mit einer Leitfähigkeit von gleich oder größer etwa 10⁻⁸ S-cm⁻¹.

11. Leitfähige polymere Zusammensetzung gemäß Anspruch 1, umfassend einen Weichmacher, gewählt aus der Gruppe, bestehend aus 4-Hexyloxyphenol, 3-Pentadecylphenol, Nonylphenol, 4-Dodecylresorcinol, 4-(tert-Octyl)phenol, 2,6-Di-tert-butyl-4-methylphenol, 3,4-Dimethylphenol, 2,6-Dimethylphenol, Methyl-p-toluolsulfonat, Ethyl-p-toluolsulfonat, n-Hexyl-p-toluolsulfonat, Ethyldodecylbenzolsulfonsäureisopropylaminalkylarylsulfonat, 1-Dodecanol, 1-Tridecanol, 1-Docosanol, Ethoxylaten der chemischen Formel (CH₃(CH₂)ₓCH₂(OCH₂CH₂)ₙOH, worin x = 10-14, n = 1,3; x = 6,8, n = 1,0; x = 10-12, n = 3; x = 6-8, n = 2 ist; Poly(oxy-1,2-ethandiyl), α-(Nonylphenoxy)-ω-hydroxy- und sulfatiertes Alkylalkoholethoxylatammoniumsalz.

12. Leitfähige polymere Zusammensetzung gemäß Anspruch 1, wobei das Substrat geschmolzenes oder flüssiges Oligomer oder Polymer umfaßt.

13. Leitfähige polymere Zusammensetzung gemäß Anspruch 12, wobei das Substrat zusätzlich ein flüssiges Lösungsmittel und/oder einen Weichmacher umfaßt.

14. Leitfähige polymere Zusammensetzung gemäß Anspruch 13, wobei das Lösungsmittel ein organisches Lösungsmittel ist.

15. Leitfähige polymere Zusammensetzung gemäß Anspruch 14, wobei das Lösungsmittel eine dielektrische Konstante kleiner als etwa 22 aufweist und wobei das Lösungsmittel aus der Gruppe gewählt ist, die aus Alkanen und Alkenen mit etwa 5 bis etwa 12 Kohlenstoffatomen, Mineralöl; Aromaten, halogenierten Aromaten, halogenierten Alkanen und aliphatischen Alkoholen, Alkylethern und Ketonen mit 4 bis etwa 12 Kohlenstoffatomen, Cycloalkanen, Cycloalkenen, Kohlenstofftetrachlorid, Kohlenstoffdisulfid, Chloroform, Bromoform, Dichlormethan, Morpholin, Anilin, Alkylbenzolen, Xylol, Toluol, Decahydronaphthalin, Styrol, Benzylalkohol, Naphthalin, Phenolen und Cresolen besteht.

16. Leitfähige polymere Zusammensetzung gemäß Anspruch 13, wobei der Weichmacher aus der Gruppe gewählt wird, die aus 4-Hexyloxyphenol, 3-Pentadecylphenol, Nonylphenol, 4-Dodecylresorcinol, 4-(tert-Octyl)phenol, 2,6-Di-tert-butyl-4-methylphenol, 3,4-Dimethylphenol, 2,6-Dimethylphenol, Methyl-p-toluolsulfonat, Ethyl-p-toluolsulfonat, n-Hexyl-p-toluolsulfonat, Ethyldodecylbenzolsulfonsäureisopropylaminalkylarylsulfonat, 1-Dodecanol, 1-Tridecanol, 1-Docosanol, Ethoxylaten der chemischen Formel (CH₃(CH₂)ₓCH₂(OCH₂CH₂)ₙOH, worin x = 10-14, n = 1,3; x = 6,8, n = 1,0; x = 10-12, n = 3; x = 6-8, n = 2 ist; Poly(oxy-1,2-ethandiyl), α-(Nonylphenoxy)-ω-hydroxy- und sulfatiertes Alkylalkoholethoxylatammoniumsalz besteht.

17. Zusammensetzung gemäß Anspruch 3, wobei das Polymer aus der Gruppe gewählt wird, umfassend Polyethylene, isotaktisches Polypropylen, Polystyrol, Poly-(ethylvinylacetat), Polybutadien, Polyisopren, Ethylen-Vinylen-Copolymere, Poly-(vinylchlorid), Ethylen-Propylen-Copolymere, Polysiloxan, Polysulfon, Polycarbonaten, Poly(ethylenterephthalat), Homo- und Copolymere von Acrylnitril, Poly(butylenterephthalat), Nylon 12, Nylon 8, Nylon 6, Nylon 6.6, Nylon 4.6, amorphe Nylonarten, Poly(vinylacetat), Poly(vinylbutyral) und Poly(vinylpyrrolidon).

18. Leitfähige polymere Zusammensetzung gemäß Anspruch 12, wobei die Zusammensetzung zu einem transparenten Leiter mit einer Leitfähigkeit von mehr als etwa 10⁻⁸ S-cm⁻¹ und einer integrierten Durchlässigkeit von mehr als 60% über dem spektralen Bereich von 485 bis 675 nm verfestigt werden kann.

19. Leitfähige polymere Zusammensetzung gemäß Anspruch 18, wobei das Substrat geschmolzenes oder flüssiges Oligomer oder Polymer umfaßt.

20. Leitfähige polymere Zusammensetzung gemäß Anspruch 18, wobei das Substrat ein flüssiges Lösungsmittel und/oder einen Weichmacher umfaßt.

21. Leitfähige polymere Zusammensetzung gemäß Anspruch 18, wobei das Substrat Lösungsmittel plus geschmolzenes oder flüssiges Oligomer oder Polymer umfaßt.

22. Leitfähige polymere Zusammensetzung gemäß Anspruch 21, wobei das Lösungsmittel aus der Gruppe gewählt wird, bestehend aus Alkanen und Alkenen mit etwa 5 bis etwa 12 Kohlenstoffatomen, Mineralöl, Aromaten, halogenierten Aromaten, halogenierten Alkanen und aliphatischen Alkoholen, Alkylethem und Ketonen mit 4 bis etwa 12 Kohlenstoffatomen, Cycloalkanen, Cycloalkenen, Kohlenstofftetrachlorid, Kohlenstoffdisulfid, Chloroform, Bromoform, Dichlormethan, Morpholin, Anilin, Alkylbenzolen, Xylol, Toluol, Decahydronaphthalin, Styrol, Naphthalin, Phenolen, Cresolen, Benzylalkohol, Epoxiden und Acrylaten.

23. Leitfähige polymere Zusammensetzung gemäß Anspruch 18, wobei die funktionalisierte protonische Säure eine Flüssigkeit mit einer dielektrischen Konstanten von gleich oder kleiner etwa 22 ist, und wobei die protonische Säure genauso als Substrat dient.

24. Leitfähiges polymeres Material gemäß mindestens einem der Ansprüche 1 bis 18, umfassend Polyanilin und eine funktionalisierte protonische Säure, welche einen Komplex mit dem Polyanilin bildet, mit einer Leitfähigkeit von gleich oder größer als etwa 10⁻⁶ S-cm⁻¹ und einer integrierten Durchlässigkeit von mehr als 60% über einen spektralen Bereich von 485 bis 675 nm.

25. Leitfähige polymere Zusammensetzung gemäß Anspruch 1 mit einer Leitfähigkeit von mehr als etwa 10⁻⁸ S-cm⁻¹ und einer integrierten Durchlässigkeit von mehr als 60% über einen spektralen Bereich von 485 bis 675 nm.

26. Leitfähige polymere Zusammensetzung gemäß Anspruch 25 mit einer Durchlässigkeit von mehr als 90% im spektralen Bereich von 475 bis 675 nm.

27. Leitfähige polymere Zusammensetzung gemäß Anspruch 26 mit einer Leitfähigkeit von mindestens 10 S-cm⁻¹ und umfassend Polyanilin und (L,D)-10-Camphersulfonsäure.

28. Verfahren zum Bilden eines leitfähigen polymeren Artikels aus einer Zusammensetzung gemäß mindestens einem der Ansprüche 1 bis 27, welches die folgenden Schritte umfaßt:
a. Bilden einer Lösung, umfassend Polyanilin, ein Substrat, einschließlich eines organischen flüssigen Lösungsmittels, welches eine dielektrische Konstante unter 22 aufweist, und gegebenenfalls ein Substratpolymer mit einer Leitfähigkeit von weniger als 10⁻⁸ S-cm⁻¹ und eine funktionalisierte protonische Säure, die in dem Lösungsmittel und dem optionalen Polymer löslich ist; und
b. Entfernen von allem oder einem Teil des Lösungsmittels von der Lösung nach oder gleichzeitig mit dem Formen der Lösung zu dem gewünschten Gegenstand.

29. Verfahren des Bildens eines leitfähigen polymeren Artikels aus einer Zusammensetzung gemäß mindestens einem der Ansprüche 1 bis 27, welches folgende Schritte umfaßt:
a. Bilden einer Lösung, umfassend Polyanilin, ein flüssiges Substrat aus organischen flüssigen Monomeren, welches eine dielektrische Konstante von unter 22 aufweist, und eine funktionalisierte protonische Säure, die in dem Substrat löslich ist; und
b. Polymerisieren der Monomeren in der Lösung, nach oder gleichzeitig mit dem Formen der Lösung zu dem gewünschten Artikel.

30. Verfahren zur Bildung eines leitfähigen polymeren Artikels aus einer Lösung, welche eine Zusammensetzung gemäß mindestens einem der Ansprüche 1 bis 27 ist, welches die folgenden Schritte umfaßt:
a. Bilden einer Lösung, umfassend Polyanilin, ein Lösungsmittel, welches eine dielektrische Konstante unter 22 aufweist, und eine funktionalisierte protonische Säure, die mit dem Lösungsmittel kompatibel ist, und Substratpolymere und ein oder mehrere Massesubstratpolymere; und
b. Entfernen von allem oder einem Teil des Lösungsmittels aus der Lösung, wodurch der leitfähige polymere Artikel entsteht.

31. Verfahren zur Bildung aus der Zusammensetzung gemäß mindestens einem der Ansprüche 1 bis 27 eines festen leitfähigen polymeren Artikels mit einem nichtleitfähigen Substratpolymeren, welches die folgenden Schritte umfaßt:
a. Bilden einer Lösung, umfassend Polyanilin, organischen flüssigen Monomer-Vorläufer zu dem Substratpolymer, und einen Lösungsstoff aus funktionalisierter protonischer Säure, der mit dem Monomer kompatibel ist; und
b. Polymerisieren des Monomeren zum Erhalt des festen Artikels.

32. Verfahren zum Bilden aus einer Zusammensetzung gemäß mindestens einem der Ansprüche 1 bis 27 eines leitfähigen Artikels aus leitfähigem Polyanilin mit Substrat durch:
a. Bilden einer Schmelze, umfassend Polyanilin und einen Lösungsstoff aus funktionalisierter protonischer Säure, der innig in ein geschmolzenes Polymersubstrat, gewählt aus der aus thermoplastischen Polymeren bestehenden Gruppe, eingemischt wird; und
b. Verfestigen der Schmelze.

33. Lichtaussendende Diode, umfassend eine transparente Elektrode, umfassend das Material gemäß mindestens einem der Ansprüche 24 bis 27.

34. Elektrisch leitfähiger Artikel, umfassend das Material gemäß mindestens einem der Ansprüche 1 bis 11, 24 bis 27 und 17, gewählt aus der Gruppe, bestehend aus Fasern, Stäben, Profilen, Folien, Beschichtungen, Membranen, Behältern, Gehäusen, und Anwendungen davon.

35. Elektrisch leitfähige Flüssigkeit, umfassend das Material gemäß mindestens einem der Ansprüche 12 bis 16 und 18 bis 23, gewählt aus der Gruppe, die aus Klebstoffen, Haftstoffen, Tinten, Lacken bzw. Anstrichen, Sprays, Ölen, Pasten und Wachsen und Anwendungen davon besteht.

36. Flexible lichtaussendende Diode, umfassend eine leitfähige Loch-injizierende Elektrode, umfassend ein leitfähiges polymeres Material gemäß Anspruch 24 und eine elektrolumineszente Schicht, umfassend ein flexibles konjugiertes Polymer.

37. Flexible lichtaussendende Diode gemäß Anspruch 36, zusätzlich umfassend einen Elektronen-injizierenden Kontakt mit einer Arbeitsfuktion unter 4,3.

38. Flexible lichtaussendende Diode gemäß Anspruch 37, zusätzlich umfassend einen flexiblen Polymerträger im Kontakt mit der leitfähigen Loch-injizierenden Elektrode.

## Revendications

1. Composition polymère conductrice comprenant :
(i) un substrat organique choisi parmi un solvant organique, un polymère en masse et des mélanges de ceux-ci, ledit substrat étant fluide ou capable d'être rendu fluide par fusion et présentant une conductivité interne de moins de 10⁻⁸ S-cm⁻¹ et une constante diélectrique, à la température ambiante, inférieure à 22 ;
(ii) une polyaniline de poids moléculaire moyen en poids supérieur à 10 000 daltons, dans laquelle les motifs répétés aniline ne sont pas substitués sur l'atome de N ; en mélange avec
(iii) une quantité efficace pour la protonation d'un acide protonique, ledit acide protonique comprenant un contre-ion qui est fonctionnalisé de manière à être soluble dans le substrat, ledit acide formant un complexe avec la polyaniline ayant une conductivité supérieure à 10⁻³ S-cm⁻¹, et répondant à la formule :
A-R₁ VI
dans laquelle :
A représente acide sulfonique, acide phosphonique, hydrogénosulfate, ou hydrogénophosphate ; et
R₁ représente 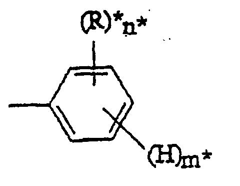
où
m* est égal à 4 et n* est égal à 1 et R* représente un groupe alkyle, alcényle ou alcoxy, comportant de 2 à 14 atomes de carbone ou un groupe alkyle substitué par un ou plusieurs restes acide carboxylique, halogène, nitro, cyano ou époxy ;
ou A représente HOSO₂⁻ et R₁ est choisi dans le groupe constitué par les restes(L,D)-10-camphre-, O-anisidine-5-, hydroxybenzène-, 2-hydroxy-4-méthoxy-benzophénone-, dinonylnaphtalène-, 4-morpholinoéthane-, et 2-{[tris(hydroxyméthyl)méthyl]amino}-1-éthane- ;
ou A représente hydrogène phosphate et R₁ représente un groupe bis(2-éthylhexyle);
ou A-R₁ représente diphénylhydrogénophosphate
ladite composition polymère conductrice, si elle est solide, présentant une microstructure comprenant une phase continue comprenant la polyaniline et l'acide protonique avec son contre-ion fonctionnalisé.

2. Composition polymère conductrice selon la revendication 1 dans laquelle le substrat comprend un solvant dans lequel le contre-ion fonctionnalisé est soluble.

3. Composition polymère conductrice selon la revendication 1 dans laquelle le substrat comprend un polymère en masse dans lequel le contre-ion fonctionnalisé est soluble.

4. Composition polymère conductrice selon la revendication 1 dans laquelle le substrat comprend un polymère en masse et un solvant, le contre-ion fonctionnalisé étant soluble dans les deux.

5. Composition polymère conductrice selon la revendication 1 comprenant au moins environ 10% de substrat et étant un solide ayant une microstructure comprenant une phase continue comprenant la polyaniline et l'acide protonique avec ledit contre-ion fonctionnalisé.

6. Composition polymère conductrice selon la revendication 1 comprenant suffisamment de polyaniline et d'acide protonique fonctionnalisé pour fournir une polyaniline protonée ayant une conductivité d'au moins environ 10⁻¹ S-cm⁻¹.

7. Composition polymère conductrice selon la revendication 1 comprenant suffisamment de polyaniline et d'acide protonique fonctionnalisé pour fournir une polyaniline protonée ayant une conductivité d'au moins environ 3 x 10² S-cm⁻¹.

8. Composition polymère conductrice selon la revendication 1 dans laquelle la polyaniline est une polyaniline présentant un poids moléculaire moyen en poids supérieur à environ 10 000 préparé par polymérisation d'une aniline de formule 1 : 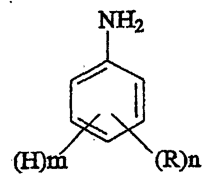 dans laquelle :
n représente un nombre entier de 0 à 4 ;
m représente un nombre entier de 1 à 5 sous réserve que la somme de n et de m soit égale à 5 ; chacun des groupe R, qui sont identiques ou différents, représente alkyle, alcényle, alcoxy, cycloalkyle, cycloalcényle, alcanoyle, alkylthio, aryloxy, alkylthioalkyle, alkylaryle, arylalkyle, alkylsulfinyle, alcoxyalkyle, alkylsulfonyle, aryle, arylthio, arylsulfinyle, alcoxycarbonyle, arylsulfonyle, acide carboxylique, halogène, cyano, ou alkyle substitué par un ou plusieurs restes acide sulfonique, acide carboxylique, halogène, nitro, cyano ou époxy ; ou deux substituants R quelconques représentent, pris ensemble, un groupe alkylène ou alcénylène complétant un cycle carboné aromatique ou alicyclique à 3, 4, 5, 6 ou 7 chaînons, lequel cycle peut comprendre un ou plusieurs hétéroatomes divalents d'azote, soufre, sulfinyle, sulfonyle ou oxygène.

9. Composition polymère conductrice selon la revendication 8 dans laquelle m est égal à 5 et n est égal à 0 de sorte que l'aniline est l'aniline non substituée.

10. Composition polymère conductrice selon la revendication 1 comprenant une polyaniline et de l'acide dodécylbenzènesulfonique qui forme un complexe avec la polyaniline dans une proportion de 5 à 95% en poids, présentant une conductivité supérieure ou égale à environ 10⁻⁸ S-cm⁻¹.

11. Composition polymère conductrice selon la revendication 1 comprenant un plastifiant choisi dans le groupe constitué par le 4-hexyloxyphénol, le 3-pentadécylphénol, le nonylphénol, le 4-dodécylrésorcinol, le 4-(tertoctyl)phénol, le 2,6-di-tert-butyl-4-méthylphénol, le 3,4-diméthylphénol, le 2,6-diméthylphénol, le p-toluènesulfonate de méthyle, le p-toluènesulfonate d'éthyle, le p-toluènesulfonate de n-hexyle, l'acide éthyldodécylbenzène-sulfonique, un alkylarylsulfonate d'isopropylamine, le 1-dodécanol, le 1-tridécanol, le 1-docosanol, des éthoxylates de formule chimique CH₃(CH₂)ₓCH₂(OCH₂CH₂)ₙOH, dans laquelle, x=10-14, n=1,3 ; x=6,8, n=1,0 ; x=10-12, n=3 ; x=6-8, n=2 ; un poly(oxy-1,2-éthanediyl),α-(nonylphénoxy)-ω-hydroxy et un sel d'ammonium d'éthoxylate d'alcanol sulfaté.

12. Composition polymère conductrice selon la revendication 1 dans laquelle le substrat comprend un oligomère ou un polymère fondu ou liquide.

13. Composition polymère conductrice selon la revendication 12 dans laquelle le substrat comprend en outre un solvant liquide et/ou un plastifiant.

14. Composition polymère conductrice selon la revendication 1 dans laquelle ledit solvant est un solvant organique.

15. Composition polymère conductrice selon la revendication 14 dans laquelle ledit solvant présente une constante diélectrique inférieure à environ 22 et dans laquelle ledit solvant est choisi dans le groupe constitué par des alcanes et des alcènes comportant d'environ 5 à environ 12 atomes de carbone, une huile minérale ; des composés aromatiques, des composés aromatiques halogénés, des alcanes halogénés, et des alcools aliphatiques, des éthers d'alkyle et des cétones comportant de 4 à environ 12 atomes de carbone, des cycloalcanes, des cycloalcènes, le tétrachlorure de carbone, le disulfure de carbone, le chloroforme, le bromoforme, le dichlorométhane, la morpholine, l'aniline, des alkylbenzènes, le xylène, le toluène, le décahydronaphtalène, le styrène, l'alcool benzylique, le naphtalène, des phénols et des crésols.

16. Composition polymère conductrice selon la revendication 13 dans laquelle ledit plastifiant est choisi dans le groupe constitué par le 4-hexyloxyphénol, le 3-pentadécylphénol, le nonylphénol, le 4-dodécylrésorcinol, le 4-(tert-octyl)phénol, le 2,6-di-tert-butyl-4-méthylphénol, le 3,4-diméthylphénol, le 2,6-diméthylphénol, le p-toluènesulfonate de méthyle, le p-toluènesulfonate d'éthyle, le p-toluènesulfonate de n-hexyle, l'acide éthyl-dodécylbenzènesulfonique, un alkylarylsulfonate d'isopropylamine, le 1-dodécanol, le 1-tridécanol, le 1-docosanol, des éthoxylates de formule chimique CH₃(CH₂)ₓCH₂(OCH₂CH₂)ₙOH, dans laquelle, x=10-14, n=1,3 ; x=6,8, n=1,0 ; x=10-12, n=3 ; x=6-8, n=2 ; un poly(oxy-1,2-éthanediyl),α-(nonylphénoxy)-ω-hydroxy et un sel d'ammonium d'éthoxylate d'alcanol sulfaté.

17. Composition polymère conductrice selon la revendication 3 dans laquelle ledit polymère est choisi dans le groupe comprenant des polyéthylènes, un polypropylène isotactique, un polystyrène, un poly(acétate d'éthylvinyle), un polybutadiène, un polyisoprène, des copolymères éthylène/vinylène, un poly(chlorure de vinyle), des copolymères éthylène/propylène, un polysiloxane, une polysulfone, des polycarbonates, un poly(téréphtalate d'éthylène), des homo- et des co-polymères d'acrylonitrile, un poly(téréphtalate de butylène), le Nylon 12, le Nylon 8, le Nylon 6, le Nylon 6,6, le Nylon 4,6, des Nylons amorphes, un poly(acétate de vinyle), un poly(vinylbutyral) et une poly(vinylpyrrolidone).

18. Composition polymère conductrice selon la revendication 12 ladite composition pouvant être solidifiée en un conducteur transparent présentant une conductivité supérieure à environ 10⁻⁸ S-cm⁻¹ et un facteur de transmission intégré de plus de 60% dans tout le domaine spectral de 485 à 675 nm.

19. Composition polymère conductrice selon la revendication 18 dans laquelle le substrat comprend un oligomère ou un polymère fondu ou liquide.

20. Composition polymère conductrice selon la revendication 18 dans laquelle le substrat comprend un solvant liquide et/ou un plastifiant.

21. Composition polymère conductrice selon la revendication 18 dans laquelle le substrat comprend un solvant et un oligomère ou un polymère fondu ou liquide.

22. Composition polymère conductrice selon la revendication 21 dans laquelle ledit solvant est choisi dans le groupe constitué par des alcanes et des alcènes comportant d'environ 5 à environ 12 atomes de carbone, une huile minérale, des composés aromatiques, des composés aromatiques halogénés, des alcanes halogénés, et des alcools aliphatiques, des éthers d'alkyle et des cétones comportant de 4 à environ 12 atomes de carbone, des cycloalcanes, des cycloalcènes, le tétrachlorure de carbone, le disulfure de carbone, le chloroforme, le bromoforme, le dichlorométhane, la morpholine, l'aniline, des alkylbenzènes, le xylène, le toluène, le décahydronaphtalène, le styrène, le naphtalène, des phénols, des crésols, l'alcool benzylique, des composés époxy et des acrylates.

23. Composition polymère conductrice selon la revendication 18 dans laquelle l'acide protonique fonctionnalisé est un liquide présentant une constante diélectrique inférieure ou égale à environ 22 et dans laquelle ledit acide protonique sert également de substrat.

24. Matériau polymère conducteur selon l'une quelconque des revendications 1 à 18 comprenant une polyaniline et un acide protonique fonctionnalisé, qui forme un complexe avec la polyaniline, ayant une conductivité supérieure ou égale à environ 10⁻⁶ S-cm⁻¹ et un facteur de transmission intégré de plus de 60% dans tout le domaine spectral de 485 à 675 nm.

25. Composition polymère conductrice selon la revendication 1 ayant une conductivité supérieure à environ 10⁻⁸ S-cm⁻¹ et un facteur de transmission intégré de plus de 60% dans tout le domaine spectral de 485 à 675 nm.

26. Composition polymère conductrice selon la revendication 25 ayant un facteur de transmission de plus de 90% dans le domaine spectral de 485 à 675 nm.

27. Composition polymère conductrice selon la revendication 26 ayant une conductivité d'au moins 10 S- cm⁻¹ et comprenant une polyaniline et de l'acide (L,D)-10-camphosulfonique.

28. Procédé de formation d'un article polymère conducteur à partir d'une composition selon l'une quelconque des revendications 1 à 27 qui comprend les étapes consistant à :
a. former une solution comprenant une polyaniline, un substrat comprenant un solvant liquide organique qui présente une constante diélectrique inférieure à 22 et facultativement un polymère de substrat ayant une conductivité inférieure à 10⁻⁸ S-cm⁻¹ et un acide protonique fonctionnalisé soluble dans ledit solvant et ledit polymère facultatif ; et
b. enlever tout ou partie dudit solvant de ladite solution après le façonnage ou simultanément au façonnage de la solution en l'article voulu.

29. Procédé de formation d'un article polymère conducteur à partir d'une composition selon l'une quelconque des revendications 1 à 27 qui comprend les étapes consistant à
a. former une solution comprenant une polyaniline, un substrat liquide de monomères liquides organiques qui présente une constante diélectrique inférieure à 22 et un acide protonique fonctionnalisé soluble dans ledit substrat ; et
b. polymériser les monomères dans ladite solution, après le façonnage ou simultanément au façonnage de la solution en l'article voulu.

30. Procédé de formation d'un article polymère conducteur à partir d'une solution qui est une composition selon l'une quelconque des revendications 1 à 27 qui comprend les étapes consistant à :
a. former une solution comprenant une polyaniline, un solvant qui présente une constante diélectrique inférieure à 22 et un acide protonique fonctionnalisé compatible avec le solvant et les polymères du substrat et un ou plusieurs polymères en masse de substrat ; et
b. enlever tout ou partie dudit solvant de ladite solution, pour produire ainsi l'article polymère conducteur.

31. Procédé de formation, à partir d'une composition selon l'une quelconque des revendications 1 à 27, d'un article polymère conducteur solide ayant un polymère de substrat non conducteur qui comprend les étapes consistant à :
a. former une solution comprenant une polyaniline, un précurseur de monomère liquide organique dudit polymère de substrat et un produit dissous d'acide protonique fonctionnalisé compatible avec ledit monomère et
b. polymériser le monomère pour obtenir l'article solide.

32. Procédé de formation, à partir d'une composition selon l'une quelconque des revendications 1 à 27, d'un article conducteur de polyaniline conductrice avec un substrat :
a. en formant un produit fondu comprenant une polyaniline et un produit dissous d'acide protonique fonctionnalisé intimement mélangé dans un substrat polymère fondu choisi dans le groupe constitué par des polymères thermoplastiques ; et
b. en solidifiant ledit produit fondu.

33. Diode émettant de la lumière comprenant une électrode transparente comprenant le matériau selon l'une quelconque des revendications 24 à 27.

34. Article électriquement conducteur comprenant le matériau selon l'une quelconque des revendications 1 à 11, 24 à 27 et 17 choisi dans le groupe constitué par des fibres, des barres, des profilés, des films, des revêtements, des membranes, des récipients, des boîtiers, et utilisations de celui-ci.

35. Liquide électriquement conducteur comprenant le matériau selon l'une quelconque des revendications 12 à 16, et 18 à 23 choisi dans le groupe constitué par des colles, des adhésifs, des encres, des peintures, des produits à pulvériser, des huiles, des pâtes et des cires, et utilisations de celui-ci.

36. Diode souple émettant de la lumière comprenant une électrode d'injection de trous conductrice comprenant un matériau polymère conducteur selon la revendication 24 et une couche électroluminescente comprenant un polymère conjugué souple.

37. Diode souple émettant de la lumière selon la revendication 36 comprenant en outre un contact d'injection d'électrons ayant un travail de sortie inférieur à 4,3.

38. Diode souple émettant de la lumière selon la revendication 37 comprenant en outre un support de polymère souple en contact avec l'électrode d'injection de trous conductrice.
